# EUROPÄISCHE PATENTSCHRIFT

(11) **EP 3 774 065 B1**
(45) Veröffentlichungstag und Bekanntmachung des Hinweises auf die Patenterteilung: **29.04.2026**
(21) Anmeldenummer: 19715442.0
(22) Anmeldetag: 29.03.2019
(51) Int. Cl.: B05B 1/08, B05C 5/02, B05C 11/10

(54) **DOSIERSYSTEM MIT PIEZOKERAMISCHEM AKTOR**
DOSING SYSTEM HAVING A PIEZOCERAMIC ACTUATOR
SYSTÈME DE DOSAGE À ACTIONNEUR PIÉZOCÉRAMIQUE

(30) Priorität: 09.04.2018 DE 102018108360
(43) Veröffentlichungstag der Anmeldung: 17.02.2021
(73) Patentinhaber: Vermes Microdispensing GmbH, 83607 Holzkirchen (DE)
(72) Erfinder: FLIESS, Mario, 81549 München (DE); STÄDTLER, Jürgen, 83620 Feldkirchen-Westerham (DE)
(74) Vertreter: Beckord & Niedlich Patentanwälte PartG mbB
(86) Internationale Anmeldenummer: PCT/EP2019/058103
(87) Internationale Veröffentlichungsnummer: WO 2019/197181

(56) Entgegenhaltungen:
- WO-A1-2009/095128
- DE-A1- 102004 004 736
- DE-A1- 102005 057 950
- DE-A1- 102008 007 202
- US-A1- 2008 223 953
- US-A1- 2015 300 748

## Beschreibung

Die Erfindung betrifft ein Dosiersystem für einen Dosierstoff mit einer Düse, einem Zuführkanal für Dosierstoff, einem Ausstoßelement und einem mit dem Ausstoßelement und/oder der Düse gekoppelten Piezoaktor. Weiterhin betrifft die Erfindung eine Verwendung eines Piezoaktors in einem Dosiersystem zur Dosierung von Dosierstoff sowie ein Verfahren zum Betrieb bzw. zur Herstellung eines solchen Dosiersystems.

Im Allgemeinen werden Dosiersysteme in verschiedensten Anwendungen dazu eingesetzt, ein zu dosierendes Medium, typischerweise ein flüssiger bis zähflüssiger Dosierstoff, gezielt zu dosieren. Im Rahmen der sogenannten "Mikrodosiertechnik" ist es dabei oftmals erforderlich, dass sehr geringe Mengen des Mediums punktgenau und zwar berührungslos, d. h. ohne einen direkten Kontakt zwischen dem Dosiersystem und einer Zieloberfläche, auf die Zieloberfläche aufgebracht werden. Ein solches kontaktloses Verfahren wird häufig auch als "Jet-Verfahren" bezeichnet. Ein typisches Beispiel dafür ist die Dosierung von Klebstoffpunkten, Lötpasten etc. bei der Bestückung von Leiterplatinen oder anderen elektronischen Elementen, oder die Aufbringung von Konverter-Materialien für LEDs.

Eine wichtige Anforderung besteht dabei darin, die Dosierstoffe hochgenau, das heißt zum richtigen Zeitpunkt, am richtigen Ort und in einer genau dosierten Menge auf die Zieloberfläche zu befördern. Dies kann beispielsweise durch eine tröpfchenweise Abgabe des Dosierstoffs über eine Düse des Dosiersystems erfolgen. Dabei kommt das Medium nur mit einem Innenraum der Düse und einem, zumeist vorderen, Bereich eines Ausstoßelements des Dosiersystems in Kontakt. Ein bevorzugtes Verfahren ist hierbei ein Ausstoß von einzelnen Tröpfchen in einer Art "Ink-Jet-Verfahren", wie es u. a. auch in Tintenstrahldruckern genutzt wird. Die Größe der Tröpfchen bzw. die Menge des Mediums pro Tröpfchen sind durch den Aufbau und die Ansteuerung sowie durch die dadurch erzielte Wirkung der Düse möglichst genau vorherbestimmbar. Alternativ kann der Dosierstoff auch in einem Strahl aufgespritzt oder in einem Nebel auf die Zieloberfläche aufgesprüht werden.

Zur Abgabe des Mediums aus dem Dosiersystem kann in der Düse des Dosiersystems ein bewegliches Ausstoßelement angeordnet sein. Das Ausstoßelement kann im Inneren der Düse mit relativ hoher Geschwindigkeit in Richtung einer Düsenöffnung bzw. Austrittsöffnung nach vorne gestoßen werden, wodurch ein Tropfen des Mediums ausgestoßen wird und anschließend wieder zurückgezogen werden.

Alternativ kann die Düse des Dosiersystems selber in einer Ausstoß- bzw. Rückzugsrichtung bewegt werden. Zur Abgabe des Dosierstoffs werden die Düse und ein im Inneren der Düse angeordnetes Ausstoßelement in einer Relativbewegung aufeinander zu bzw. voneinander weg bewegt. Dabei kann die Relativbewegung entweder alleinig durch eine Bewegung der Austrittsöffnung bzw. der Düse erfolgen oder zumindest teilweise auch durch eine entsprechende Bewegung des Ausstoßelements.

Üblicherweise kann das Ausstoßelement zudem in eine Verschlussstellung gebracht werden, indem es in der Düse an einem Dichtsitz der Düsenöffnung fest anschließt und dort vorübergehend verbleibt. Bei zähflüssigeren Dosierstoffen kann es auch ausreichen, dass das Ausstoßelement einfach in der Rückzugsstellung, d. h. vom Dichtsitz entfernt verbleibt, ohne dass ein Tropfen des Mediums austritt.

Da der grundsätzliche Aufbau der unterschiedlichen Arten von Dosiersystemen mit Piezoaktoren sowie die jeweils zugrunde liegenden Funktionsprinzipien allgemein bekannt sind, wird hier nicht näher darauf eingegangen.

Unabhängig vom konkreten Ausstoß- bzw. Funktionsprinzip des Dosiersystems erfolgt zur Dosierung des Dosierstoffs also stets eine relative Lageveränderung des Ausstoßelements und der Düse bzw. der Austrittsöffnung zueinander. Die dazu notwendige Bewegung des Ausstoßelements und/oder der Austrittsöffnung erfolgt üblicherweise mit Hilfe eines Aktorsystems des Dosiersystems. Ein solches Aktorsystem kann auf verschiedene Weise realisiert sein, wobei insbesondere bei Anwendungen, die eine hochfeine Dosierungsauflösung erfordern, bevorzugt Dosiersysteme mit Piezoaktoren Verwendung finden. Piezoaktoren, die auch als piezoelektrisch betriebene Aktoren bezeichnet werden, haben gegenüber anderen Arten, bzw. nach anderen Prinzipien arbeitenden Aktoren den Vorteil der sehr präzisen und vor allem schnelleren Steuerbarkeit. Vorteilhafterweise zeichnen sich Piezoaktoren durch äußert kurze Reaktions- bzw. Ansprechzeiten aus. So liegt die mögliche Ansprechzeit eines Piezoaktors mit einem typischen Wert von weniger als 0,1ms deutlich unter den entsprechenden Werten von anderen Aktorprinzipien. Ein weiterer Vorteil besteht darin, dass Piezoaktoren gegenüber anderen Arten von Aktoren vergleichsweise wenig Bauraum innerhalb eines Dosiersystems beanspruchen. Somit stellen Piezoaktoren eine effiziente Lösung für den Betrieb von Dosiersystemen dar, insbesondere bei hochfeinen Dosierungsanforderungen.

Ungeachtet dieser Vorteile hat sich die Zuverlässigkeit von Piezoaktoren in Dosiersystemen in der Vergangenheit häufig als unzureichend herausgestellt. Bedingt durch eine hohe elektrische Feldstärke, die während des Betriebs des Dosiersystems an einer Oberfläche des Piezoaktors anliegt, werden polare Moleküle, z. B. Wassermoleküle, aus der Umgebungsluft des Aktors bzw. des Dosiersystems angezogen und führen zu einer erhöhten Leitfähigkeit an der Aktoroberfläche, insbesondere bei keramischen Piezoaktoren. Infolge des ansteigenden Leckstroms muss der Piezoaktor unter Umständen schon nach einer kurzen Einsatzdauer ersetzt werden, wobei das gesamte Dosiersystem für einen gewissen Zeitraum ausfällt. Dadurch wird die Effizienz des Dosiersystems unnötigerweise verringert.

DE 10 2008 007202 zeigt ein Dosiersystem gemäß dem Stand der Technik.

Es ist daher eine Aufgabe der vorliegenden Erfindung, ein Dosiersystem mit einem Piezoaktor, eine Verwendung eines Piezoaktors in einem Dosiersystem sowie ein jeweiliges Verfahren zum Betrieb bzw. zur Herstellung eines Dosiersystem mit einem Piezoaktor bereit zu stellen, mit dem die zuvor erläuterten Nachteile vermieden werden können.

Diese Aufgabe wird durch ein Dosiersystem gemäß Patentanspruch 1, eine Verwendung eines Piezoaktors in einem Dosiersystem nach Patentanspruch 12 sowie durch ein Verfahren zum Betrieb eines Dosiersystems nach Patentanspruch 13 und ein Verfahren zur Herstellung eines Dosiersystems nach Patentanspruch 14 gelöst.

Ein erfindungsgemäßes Dosiersystem für einen flüssigen bis zähflüssigen Dosierstoff umfasst zumindest eine Düse, einen Zuführkanal für Dosierstoff, ein Ausstoßelement und wenigstens einen mit dem Ausstoßelement und/oder der Düse gekoppelten Piezoaktor, um das Ausstoßelement und/oder die Düse relativ zueinander zu bewegen. Der zu dosierende Dosierstoff gelangt durch einen Zuführkanal des Dosiersystems in einen die Düse umfassenden Bereich des Dosiersystems.

Die Abgabe des Dosierstoffs aus dem erfindungsgemäßen Dosiersystem kann nach einer der eingangs erläuterten Arten erfolgen, d. h. das Dosiersystem ist nicht auf ein konkretes Ausstoß- bzw. Funktionsprinzip beschränkt. Entsprechend kann - wie das meist der Fall ist - in der Düse des Dosiersystems (insbesondere im Bereich der Düse z.B. kurz vor der Austrittsöffnung) ein mit relativ hoher Geschwindigkeit bewegbares Ausstoßelement zum Ausstoßen des Dosierstoffs aus der Düse angeordnet sein. Alternativ oder zusätzlich kann wie erwähnt eine Austrittsöffnung des erfindungsgemäßen Dosiersystems bewegbar ausgebildet sein. Die Austrittsöffnung bezeichnet eine zur Düse des Dosiersystems zugehörige vom Inneren des Dosiersystems nach außen führende Öffnung (wobei es sich auch um einen - in der Regel sehr kurzen - Kanal handeln kann) zur Abgabe des Dosierstoffs aus dem Dosiersystem. Zur Bewegung der Austrittsöffnung können zumindest Bereiche bzw. ein Bauteil der Düse, welche die Austrittsöffnung umfassen, gegenüber anderen unbeweglichen Teilen des Dosiersystems in einer Ausstoß- und/oder Rückzugsrichtung beweglich ausgebildet sein.

Bei dem erfindungsgemäßen Dosiersystem wird der Dosierstoff durch das Ausstoßelement selbst aus der Düse ausgestoßen. Zum Ausstoßen aus der Düse kommt das Ausstoßelement in Kontakt mit dem abzugebenden Dosierstoff und "drückt" bzw. "schiebt" den Dosierstoff auf Grund einer Bewegung des Ausstoßelements und/oder der Düse aus der Düse des Dosiersystems hinaus. Mittels des Ausstoßelements wird der Dosierstoff quasi "aktiv" aus der Düse ausgestoßen. Damit unterscheidet sich das erfindungsgemäße Dosiersystem von anderen Dispenser-Systemen, bei denen eine Bewegung eines Verschlusselements lediglich zu einer Öffnung der Düse führt, wobei der unter Druck stehende Dosierstoff dann von selbst aus der Düse austritt. Dies ist z. B. bei Einspritzventilen von Verbrennungsmotoren der Fall.

In Abhängigkeit der konkreten (zuvor erläuterten) Ausgestaltung des erfindungsgemäßen Dosiersystems erfolgt die Bewegung des Ausstoßelements und/oder der Austrittsöffnung durch eine jeweilige Kopplung des Ausstoßelements und/oder der Austrittsöffnung (d. h. des Bauteils mit der Austrittsöffnung) mit zumindest einem Piezoaktor des Dosiersystems.

Grundsätzlich erfolgt die Kopplung dabei unabhängig vom konkreten Ausstoßprinzip des erfindungsgemäßen Dosiersystems so, dass die vom Piezoaktor ausgeübten Kräfte und Bewegungen so weitergeleitet werden, dass hieraus die gewünschte Bewegung der jeweils bewegbaren Elemente des Dosiersystems, also des Ausstoßelements und/oder der Austrittsöffnung, zur Abgabe des Dosierstoffs aus der Düse resultiert. Der zumindest eine Piezoaktor ist dabei so ausgebildet und angeordnet, dass er die jeweils beweglichen Elemente des Dosiersystems direkt und/oder indirekt, beispielsweise mittels eines Bewegungsmechanismus, bewegen kann.

Bevorzugt kann der Bewegungsmechanismus ein Kopplungselement umfassen, um die Bewegungen des Piezoaktors an ein bewegliches Element des Dosiersystems zu übertragen. Besonders bevorzugt kann das Kopplungselement ein Übersetzungselement aufweisen, um eine Auslenkung des Piezoaktors um einen bestimmten Wert bzw. Faktor zu erhöhen. Insbesondere kann das Übersetzungselement ausgebildet sein, um ein bestimmtes Übersetzungs-Verhältnis zwischen einer Auslenkung bzw. einem Hub des Piezoaktors und einer daraus resultierenden Bewegung bzw. einem Hub eines beweglichen Elements des Dosiersystems zu erzeugen. Mittels des Übersetzungselements kann eine Auslenkung des Piezoaktors in eine bestimmte, gewünschte Auslenkung des beweglichen Elements des Dosiersystems übersetzt werden.

Insbesondere auf Grund eines derartigen Übersetzungselements ist das Dosiersystem besonders auch geeignet zur Dosierung von Dosierstoffen mit einer mittleren und hohen Viskosität von z. B. bis zu 0,5 Pa*s, vorzugsweise von bis zu 1 Pa*s, besonders bevorzugt von bis zu 1000 Pa*s.

Das Übersetzungselement kann z. B. einen verkippbar gelagerten Hebel umfassen, der in Wirkkontakt mit dem Piezoaktor und einem beweglichen Ausstoßelement des Dosiersystems, z. B. einem Stößel, steht. Das bedeutet, ein Hebelarm des Hebels ist dazu ausgebildet, ein bestimmtes Übersetzungs-/Hubverhältnis zu erzeugen.

Erfindungsgemäß ist der wenigstens eine Piezoaktor des Dosiersystems hermetisch dicht in ein Gehäuse eingekapselt. Bevorzugt kann ein monolithischer piezokeramischer Aktor, insbesondere piezokeramischer Vielschichtaktor, bzw. ein monolithischer piezoelektrisch betriebener Vielschichtaktor in einer hermetisch verschlossenen Umhüllung angeordnet sein. Das Gehäuse mit dem darin angeordneten Piezoaktor sowie ggf. weiteren, dem Gehäuse zugeordneten Elementen, wird nachfolgend als Aktoreinheit bezeichnet.

Im Rahmen der Erfindung wird unter einer "hermetisch dichten Einkapselung" verstanden, dass das den piezokeramischen Aktor umgebende Gehäuse so dicht verschlossen ist, dass keine Stoffe bzw. Substanzen von außen in das Gehäuse eindringen können. Umgekehrt bedeutet dies, dass auch keine Stoffe aus einem Inneren des Gehäuses nach außen entweichen können. Insbesondere ist das Gehäuse so ausgebildet, dass es undurchlässig für Wasser bzw. Feuchtigkeit im Allgemeinen ist.

Bevorzugt ist das Gehäuse dazu ausgebildet, eine im Inneren des Gehäuses angeordnete und den piezokeramischen Aktor umgebende "Atmosphäre" für einen bestimmten Zeitraum im Wesentlichen konstant aufrechtzuerhalten. Insbesondere kann mittels des hermetisch verschlossenen Gehäuses eine vorgegebene "Atmosphäre" auch während des Betriebs des gekapselten piezokeramischen Aktors im Dosiersystem, d. h. bei Betrieb des erfindungsgemäßen Dosiersystems, im Inneren des Gehäuses überwiegend unverändert beibehalten werden. Eine detaillierte Beschreibung der "Atmosphäre" sowie des den piezokeramischen Aktor umgebenden Gehäuses wird an anderer Stelle gegeben.

Die Erfindung betrifft weiterhin eine Verwendung von zumindest einem hermetisch dicht in ein Gehäuse eingekapselten Piezoaktor in einem Dosiersystem zur Dosierung von flüssigem bis zähflüssigem Dosierstoff. Bevorzugt wird der eingekapselte Piezoaktor in einem zuvor erläuterten erfindungsgemäßen Dosiersystem verwendet.

Vorteilhafterweise wird bei dem erfindungsgemäßen Dosiersystem mit zumindest einem hermetisch eingekapselten Piezoaktor bzw. durch die Verwendung eines solchen hermetisch in ein Gehäuse eingekapselten Piezoaktors in einem Dosiersystem erreicht, dass der Piezoaktor auch während des Betriebs des Dosiersystems von schädlichen bzw. nachteiligen äußeren (Umwelt-)Einflüssen des Dosiersystems überwiegend vollständig abgeschirmt ist. Somit kann die Verwendungsdauer bzw. "Langlebigkeit" des Piezoaktors in dem erfindungsgemäßen Dosiersystem erhöht werden, so dass die Häufigkeit des Auswechselns von defekten Piezoaktoren gegenüber Dosiersystemen herkömmlicher Bauart, d. h. ohne Kapselung des Piezoaktors, erheblich reduziert werden kann. Vorteilhafterweise kann dadurch auch die (unterbrechungsfreie) Einsatzdauer des erfindungsgemäßen Dosiersystems deutlich erhöht werden.

Durch eine Verringerung von unerwünschten bzw. außerplanmäßigen Standzeiten des erfindungsgemäßen Dosiersystems, welche sich in Folge eines Aktor-Wechsels unausweichlich ergeben, kann die Effizienz des erfindungsgemäßen Dosiersystems gegenüber herkömmlichen Dosiersystemen erheblich gesteigert werden. Weiterhin ist es vorteilhaft, dass das erfindungsgemäße Dosiersystem in neuen, insbesondere für vergleichbare Dosiersysteme herkömmlicher Bauart ungeeigneten Einsatzbereichen verwendet werden kann, z. B. in Umgebungen mit einer sehr hohen Luftfeuchtigkeit oder sogar unter Wasser.

Bei einem erfindungsgemäßen Verfahren zum Betrieb eines Dosiersystems zur Dosierung von Dosierstoff mit einem hermetisch in ein Gehäuse eingekapselten Piezoaktor, wobei das Dosiersystem vorzugsweise einem zuvor erläuterten erfindungsgemäßen Dosiersystem entspricht, wird der Betrieb des Dosiersystems besonders bevorzugt in Abhängigkeit zumindest eines Betriebsparameters des eingekapselten Piezoaktors geregelt. Vorzugsweise wird der Betriebsparameter während des laufenden Betriebs des Dosiersystems mittels zumindest eines im Inneren des Gehäuses angeordneten Sensors ermittelt. Ein dem Betriebsparameter zugrunde liegender (Mess-)Wert kann an eine Steuereinheit des Dosiersystems übertragen werden, wobei mittels der Steuereinheit der laufende Betrieb des Dosiersystems in Abhängigkeit des Messwerts (Istwert) so geregelt werden kann, dass ein vorgebbarer Sollwert des Betriebsparameters aufrecht erhalten bzw. erreicht wird. Insofern umfasst eine Steuereinheit im Rahmen der Erfindung auch Merkmale einer Regeleinheit.

Bei einem erfindungsgemäßen Verfahren zur Herstellung eines Dosiersystems zur Dosierung von Dosierstoff mit einem Piezoaktor, vorzugsweise zur Herstellung eines erfindungsgemäßen Dosiersystems, wird zumindest ein Piezoaktor hermetisch in ein Aktoreigenes Gehäuse (Aktor-Gehäuse) eingekapselt. Das Gehäuse des Piezoaktors (Aktor-Gehäuse) wird dann in ein Gehäuse (Gehäuseblock) des Dosiersystems eingesetzt. Dabei kann der Piezoaktor mitsamt seinem Aktor-Gehäuse in dem Gehäuseblock des Dosiersystems so angeordnet sein, dass er ringsum vom Gehäuseblock umschlossen ist, er kann aber auch (zumindest teilweise) von außen zugänglich sein, z. B. in einer offenen Aussparung des Gehäuseblocks gelagert sein.

Weitere, besonders vorteilhafte Ausgestaltungen und Weiterbildungen der Erfindung ergeben sich aus den abhängigen Ansprüchen sowie der nachfolgenden Beschreibung.

Als Piezoaktor bzw. piezoelektrisch betriebener Aktor, insbesondere piezokeramischer Aktor, wird im Zusammenhang der Erfindung ein solches Bauteil definiert, das zwar aus mehreren Elementen, z. B. mehreren übereinander geschichteten Piezokristallen bzw. Schichten eines piezoelektrisch aktiven Materials, insbesondere Keramik, ausgebildet sein kann, jedoch einen Verbund bildet, der als Gesamtheit von einer Steuereinheit angesteuert wird, das heißt, z. B. einen gemeinsamen elektrischen Anschluss zur Ansteuerung seiner enthaltenen Einzelelemente aufweist.

Bei dem gekapselten Piezoaktor des Dosiersystems, welches dieser Erfindung zugrunde liegt, handelt es sich, abgesehen von dem Gehäuse, bevorzugt um einen monolithischen piezokeramischen Vielschichtaktor mit einer Anzahl von gestapelten Schichten eines piezoelektrisch aktiven Materials (z. B. Blei-Zirkonat-Titanat) sowie zwischen den einzelnen Schichten angeordneten leitfähigen Innenelektroden. Vorzugsweise sind die Innenelektroden alternierend an eine Oberfläche des Aktors geführt, elektrisch parallel geschaltet und zu zwei Gruppen zusammengefasst, welche die beiden Anschlusspole des piezokeramischen Aktors bilden. Der grundsätzliche Aufbau von ungekapselten piezokeramischen Aktoren ist z. B. aus der EP 0 844 678 A1 bekannt.

Grundsätzlich wäre es im Rahmen der Erfindung möglich, eine Mehrzahl, d. h. zwei oder mehr der zuvor erläuterten Piezoaktoren zur Verwendung in dem erfindungsgemäßen Dosiersystem in einem gemeinsamen Gehäuse hermetisch einzukapseln. Dennoch wird, sofern nicht explizit anders erwähnt, in der nachfolgenden Beschreibung der Einfachheit halber davon ausgegangen, dass ein einzelner Piezoaktor, vorzugsweise ein piezokeramischer Aktor, in ein Gehäuse hermetisch eingeschlossen ist, ohne die Erfindung darauf zu beschränken.

Je nach konkreter Ausgestaltung des erfindungsgemäßen Dosiersystems kann es bevorzugt sein, dass eine Mehrzahl von jeweils einzeln eingekapselten piezokeramischen Aktoren in einem einzigen erfindungsgemäßen Dosiersystem angeordnet ist. Hierzu könnten ein erster gekapselter Piezoaktor und ein zweiter gekapselter Piezoaktor hintereinander so angeordnet sein, so dass die jeweiligen Längen der beiden Piezoaktoren nahezu aufaddiert werden können. Sofern die beiden gekapselten Piezoaktoren parallel zueinander angeordnet sind, können die in einem Moment ausgeübten Kräfte der beiden Piezoaktoren im Wesentlichen aufaddiert werden.

Alternativ oder zusätzlich könnte in dem erfindungsgemäßen Dosiersystem auch eine Mehrzahl von jeweils gekapselten Piezoaktoren in ihrer Bewegung gegengleich geschaltet und/oder ausgerichtet sein, z. B. nach der Art einer "Push-Push-Anordnung". Ein nach diesem Grundprinzip arbeitendes Dosiersystem, wenngleich ohne gekapselte Piezoaktoren, ist aus der EP 2 969 248 B1 bekannt.

Entsprechend kann gemäß einer Ausführungsform des erfindungsgemäßen Dosiersystems jeweils einer von zwei gekapselten Piezoaktoren des Dosiersystems die Austrittsöffnung bzw. ein Bauteil der Düse, welches die Austrittsöffnung umfasst, direkt oder indirekt in eine vorgegebene Richtung schieben. Das bedeutet, während sich ein erster der beiden gekapselten Piezoaktoren ausdehnt und die Austrittsöffnung in eine Richtung schiebt, zieht sich der zweite gekapselte Piezoaktor zusammen und gibt so den notwendigen Platz für die Bewegung der Austrittsöffnung in die gewünschte Richtung frei. Zur Bewegung der Austrittsöffnung in die andere (entgegengesetzte) Richtung werden die jeweiligen Funktionen der gekapselten Piezoaktoren umgedreht, d. h. der zweite Piezoaktor dehnt sich wieder aus und schiebt nun die Austrittsöffnung, während sich der erste Piezoaktor zusammenzieht.

Vorteilhafterweise kann die Erfindung bei allen gängigen bzw. in der Einleitung erläuterten Arten von Dosiersystemen mit Piezoaktoren zum Einsatz kommen, also unabhängig vom konkreten Ausstoßprinzip. Daher können bei dem erfindungsgemäßen Dosiersystem das bewegliche Ausstoßelement und/oder die bewegliche Austrittsöffnung, jeweils mit einer Anzahl von gekapselten piezokeramischen Aktoren des erfindungsgemäßen Dosiersystems gekoppelt sein, wobei der Begriff "Anzahl" so zu verstehen ist, dass das betreffende Merkmal einfach oder mehrfach vorhanden sein kann.

Dennoch wird die Erfindung - ohne Beschränkung darauf - der besseren Verständlichkeit wegen nachfolgend anhand eines Dosiersystems beschrieben, bei welchem die Abgabe des Dosierstoffs einzig mittels eines beweglichen Ausstoßelements erfolgt, wobei die Bewegung des Ausstoßelements mittels nur eines einzigen gekapselten Piezoaktors erfolgt. Das Ausstoßelement ist, wie eingangs erläutert, bevorzugt dazu ausgebildet, eine Düsenöffnung im Wesentlichen vollständig zu verschließen oder einem der Düsenöffnung innen aufgelagerten Dichtsitz fest anzuschließen, so dass das Dosiersystem verschlossen wird.

Die Bewegung des Ausstoßelements erfolgt, wie bereits erläutert, mittels zumindest eines hermetisch eingekapselten Piezoaktors des Dosiersystems. Bevorzugt ist das den Piezoaktor hermetisch einschließende Gehäuse, also das Aktor-Gehäuse, "dauerschwingfest" ausgebildet.

Unter "dauerschwingfest" bzw. "dauerfest" wird im Rahmen der Erfindung verstanden, dass im Rahmen einer typischen Lebensdauer des im Gehäuse angeordneten Piezoaktors selbst, d. h. nach einer Anzahl von Schwingungen (Auslenkungen), die der Piezoaktor ungeachtet der Kapselung im Betrieb des Dosiersystems (konstruktionsbedingt) üblicherweise durchlaufen kann, am Gehäuse selbst keine Ermüdungserscheinungen auftreten. Bevorzugt ist das Gehäuse so ausgebildet, dass beim Piezoaktor kein Versagensverhalten auftritt. Insbesondere soll ein Auftreten von Leckströmen an der Aktoroberfläche bzw. die Zunahme solcher Leckströme über einen vorgebbaren (tolerierbaren) Grenzwert hinaus, ausreichend "dauerhaft" verhindert werden. Unter ausreichend "dauerhaft" ist im Rahmen der Erfindung zu verstehen, dass die zuvor genannten vorteilhaften Merkmale des Gehäuses im Rahmen einer typischen Einsatz- bzw. Verwendungsdauer des gekapselten Piezoaktors in einem Dosiersystem unter den dabei üblicherweise auftretenden Bedingungen im Wesentlichen vollumfänglich erhalten bleiben. Dabei wird z. B. vorausgesetzt, dass die Auslenkung des gekapselten Piezoaktors in einem bei der Verwendung von Piezoaktoren in Dosiersystemen üblichen Rahmen liegt. Typischerweise kann eine Auslenkung des (expandierten) Piezoaktors z. B. 1,4‰ bis 1,7%o des ruhenden Piezoaktors betragen.

Vorzugsweise ist das Gehäuse so ausgebildet, dass das Gehäuse während der Verwendung der Aktoreinheit im Dosiersystem, also im Betrieb des Dosiersystems, ausreichend "dauerhaft" intakt bleibt. Mit anderen Worten sollen Ermüdungserscheinungen wie ein Auftreten von Rissen, Schlitzen, Spalten, Brüchen oder andersartigen Undichtigkeiten im Bereich des Gehäuses unter den im Betrieb des Dosiersystems üblicherweise auftretenden Bedingungen (z. B. hinsichtlich der Frequenz und des Betrags der Auslenkung, der Temperatur im Dosiersystem etc.) verhindert werden. Bevorzugt ist das Gehäuse dazu ausgebildet, eine ausreichend "dauerhafte" und kontinuierlich wirksame hermetische Diffusionsbarriere für Stoffe bzw. Substanzen zwischen einem Inneren des Gehäuses und einem das Gehäuse umgebenden Äußeren auszubilden, insbesondere für Feuchtigkeit, z. B. für die Zeitspanne eines typischen (routinemäßigen) Wartungsintervalls des Dosiersystems. Bevorzugt ist das Gehäuse "diffusionsdicht" ausgebildet. Vorzugsweise ist das Gehäuse also derart ausgebildet, dass es auch nach einer Anzahl von wenigstens 1*10^9, besonders bevorzugt von wenigstens 1*10^10, Zyklen bzw. Auslenkungen des gekapselten Piezoaktors vollständig intakt ist.

Vorteilhafterweise kann mittels eines dauerschwingfest ausgebildeten Gehäuses erreicht werden, dass das Dosiersystem für eine vorgebbare Zeitspanne, z. B. ein Wartungszyklus des Dosiersystems, überwiegend unterbrechungsfrei (zumindest was die Funktion des Piezoaktors betrifft) betrieben werden kann. Damit können unerwünschte Standzeiten des Dosiersystems reduziert werden, wobei die Effizienz des Dosiersystems gesteigert wird.

Um eine Dauerschwingfestigkeit des Gehäuses zu erreichen, kann das Gehäuse überwiegend mittels eines metallischen Werkstoffs realisiert sein. Alternativ könnten einzelne Bereiche des Gehäuses auch aus einem anderen, also nicht-metallischen, Werkstoff ausgebildet sein. Beispielsweise könnte ein Gehäuseboden und/oder -deckel einen keramischen Grundstoff umfassen oder mittels einer biegsamen Membran realisiert sein. Auch andersartige Werkstoffe sind denkbar, solange sie eine ausreichend dauerhafte hermetische Verschließung des Gehäuses, im oben definierten Sinn, auch während des Betriebs des Dosiersystems ermöglichen.

Bevorzugt kann das Gehäuse zumindest abschnittsweise nach der Art eines faltenartigen Metall-Balgs ausgebildet sein. Dazu kann das Gehäuse einen, vorzugsweise planparallelen, Gehäuse-Boden, sowie einen sich daran anschließenden und fest damit verbundenen länglichen Grundkörper bzw. Gehäusemantel, z. B. ein Metallrohr, umfassen. In den Gehäusemantel kann zumindest in Teilbereichen ein Faltenbalg eingearbeitet sein. Den oberen Abschluss des Gehäuses bildet ein fest mit dem Gehäusemantel verbundener, vorzugsweise planparalleler, Gehäusedeckel.

Vorzugsweise ist ein sich innerhalb des verschlossenen Gehäuses ausbildender Innenraums derart bemessen, dass ein Piezoaktor der zuvor erläuterten Art, vorzugsweise entlang seiner Längserstreckung vollständig zwischen dem Gehäuseboden und dem Gehäusedeckel angeordnet werden kann. Bevorzugt kann der Piezoaktor so im Innenraum des verschlossenen Gehäuses angeordnet sein, dass die jeweiligen Enden bzw. Endbereiche des Piezoaktors dem Gehäuseboden bzw. -deckel direkt aufliegen, insbesondere wenn sich der Piezoaktor in einem ruhenden, also nicht expandierten Zustand, befindet. Vorzugsweise kann zumindest ein Endbereich des Piezoaktors, z. B. ein Aktor-Fuß, fest mit dem Gehäuseboden verbunden sein.

Bevorzugt kann das Gehäuse so ausgestaltet sein, dass eine Oberfläche des im Gehäuse angeordneten Piezoaktors und eine Innenwandung des Gehäuses, zumindest im Bereich des Gehäusemantels, einander nicht berühren. Mit anderen Worten kann ein innerer Querschnitt des Gehäusemantels bzw. des Gehäuses, welcher im Wesentlichen quer zur Längserstreckung des Gehäuses verläuft, vorzugsweise größer als ein entsprechender Querschnitt des im Gehäuse angeordneten Piezoaktors sein.

Vorteilhafterweise kann durch die zumindest partielle Ausgestaltung des Gehäuses nach der Art eines metallischen Faltenbalgs erreicht werden, dass das Gehäuse zumindest teilweise nachgiebig ausgebildet ist, wobei eine Steifigkeit des Gehäuses reduziert wird. Somit kann eine möglichst freie bzw. ungehinderte Ausdehnung des Piezoaktors im Gehäuse bei angelegter Spannung erfolgen. Vorteilhafterweise kann dadurch erreicht werden, dass im Wesentlichen die gesamte vom Piezoaktor erzeugte Kraft zur Bewegung des Ausstoßelements bzw. der Düse des Dosiersystems genutzt werden kann. Somit vereint das Dosiersystem die Vorteile eines gekapselten Piezoaktors (z. B. höhere Effizienz des Dosiersystems) mit den Vorteilen eines ungekapselten Piezoaktors (z. B. kaum zusätzlicher Widerstand durch das Gehäuse).

Piezoaktoren können ein temperaturabhängiges Verhalten aufweisen. Dies betrifft gleichermaßen die Auslenkung des Piezoaktors unter Spannung sowie die Abmessung des Piezoaktors im ruhenden Zustand. Die Temperatur des Piezoaktors kann somit unmittelbare Auswirkungen auf die Funktionsfähigkeit des Dosiersystems haben und kann z. B. die Bewegung und/oder Lage des Ausstoßelements auf unerwünschte Weise beeinflussen.

Zur Überwachung der Temperatur kann daher vorzugsweise zumindest ein Temperatursensor im Inneren bzw. im Innenraum des Gehäuses angeordnet sein. Alternativ oder zusätzlich kann zumindest ein Temperatursensor auf bzw. an einer vom gekapselten Piezoaktor bzw. vom Innenraum des Gehäuses weg weisenden Außenseite des Gehäuses angeordnet sein. Lediglich der besseren Verständlichkeit wird nachfolgend davon ausgegangen, dass zumindest ein Temperatursensor im Inneren des Gehäuses angeordnet ist, ohne die Erfindung darauf zu beschränken.

Vorzugsweise kann ein Temperatursensor im Inneren des Gehäuses in einem Bereich zwischen dem Aktor und einer Innenwandung des Gehäuses angeordnet sein. Die Innenwandung des Gehäuses umfasst eine jeweilige Innenseite des Gehäusebodens, - mantels und -deckels, also alle Bereiche bzw. Flächen des Gehäuses, die dem Piezoaktor zur Einkapselung bzw. zur Ausbildung des Innenraum des Gehäuses zugewandt sind. Beispielsweise könnte ein Temperatursensor in einem jeweils mittleren Bereich zwischen dem Piezoaktor und der Innenwandung bzw. zwischen Gehäuseboden und -deckel, also frei im Gehäuse "schwebend" angeordnet sein. Die Temperatur im Gehäuse kann dazu genutzt werden, um den Betrieb des Dosiersystems (in Abhängigkeit dieses Betriebsparameters) zu regeln, wie nachfolgend erläutert wird.

Vorzugsweise kann zumindest ein Temperatursensor an bzw. auf einer Außenseite des Piezoaktors angeordnet sein. Bevorzugt kann der Temperatursensor so auf der Aktor-Außenseite angeordnet sein, dass der Temperatursensor in Messkontakt mit der Außenseite des Aktors steht. Die Aktor-Außenseite wird synonym auch als Aktoroberfläche bezeichnet.

Der Temperatursensor bzw. Temperaturfühler kann so auf der Aktoroberfläche angeordnet sein, dass die Temperatur in unmittelbarer Nähe zur Aktoroberfläche gemessen wird. Alternativ oder zusätzlich könnte auch die Temperatur der Aktoroberfläche selber gemessen werden, z. B. als Maß bzw. Gradmesser für eine Temperatur im Aktorkern.

Bevorzugt kann auch eine Mehrzahl von Temperatursensoren in Messkontakt mit der Außenseite des Aktors angeordnet sein. Um z. B. einen Temperaturgradienten entlang der Längserstreckung des Piezoaktors zu erfassen, können besonders bevorzugt mehrere Temperatursensoren in unterschiedlichen Bereichen der Aktoroberfläche angeordnet werden. Unter der Längserstreckung wird dabei die größte bzw. längste Erstreckung des Piezoaktors in eine Richtung verstanden.

Vorzugsweise kann eine Anzahl von Temperatursensoren in den peripheren (End-)Bereichen des Piezoaktors angeordnet sein, welche den jeweiligen äußeren Abschluss des Piezoaktors entlang seiner Längserstreckung bilden, und als Fuß- bzw. Kopfbereich des Piezoaktors bezeichnet werden. Besonders bevorzugt können auch in einem mittig zwischen den beiden gegenüberliegenden peripheren Endbereichen befindlicher Zentralbereich des Piezoaktors ein oder mehrere Temperatursensoren angeordnet sein. Insbesondere der Zentralbereich kann durch eine vergleichsweise hohe Temperatur gekennzeichnet sein. Dies betrifft sowohl die Aktoroberfläche wie auch den Aktorkern.

Darüber hinaus kann zumindest ein Temperatursensor an bzw. auf der Innenwandung des Gehäuses angeordnet sein. Bevorzugt kann eine Anzahl von Temperatursensoren in Messkontakt mit der Innenseite Gehäusemantels angeordnet sein. Beispielsweise könnten Temperatursensoren auf einer oder mehreren Auswölbungen bzw. Einbuchtungen des balgartig ausgebildeten Gehäusemantels realisiert sein.

Zusätzlich oder alternativ könnte eine Anzahl von Temperatursensoren im Bereich des Gehäusebodens und/oder -deckels angeordnet sein, insbesondere in unmittelbarer Nähe zu einem Fuß- bzw. Kopfbereich des Piezoaktors oder einer später noch erläuterten Durchführung durch das Gehäuse.

Besonders bevorzugt können die Temperatursensoren so im Gehäuse angeordnet sein, dass sich die auf der Innenwandung, insbesondere am Gehäusemantel, und die auf der Aktoroberfläche angeordneten Temperatursensoren im Wesentlichen gegenüberliegen bzw. einander direkt zugewandt sind. Vorteilhafterweise kann damit ein Temperaturgradient zwischen dem jeweiligen Bereich der Aktoroberfläche und dem jeweils gegenüberliegenden Bereich des Gehäuses bzw. des Gehäusemantels ermittelt werden, um so beispielsweise Rückschlüsse auf die Effektivität einer Kühleinrichtung des Dosiersystems zu gewinnen.

Bevorzugt kann ein Temperatursensor auch im Inneren des piezokeramischen Aktors bzw. in einem Kern (Aktorkern) des piezokeramischen Aktors angeordnet sein. Mit anderen Worten kann der Temperatursensor in Messkontakt mit einem Inneren des Aktors angeordnet sein. Unter dem Aktorkern wird bei einer Draufsicht auf einen quer geschnittenen Piezoaktor der zentrale, mittige Bereich des Querschnitts des Piezoaktors verstanden. Der Aktorkern verläuft demnach kontinuierlich entlang der Längserstreckung des Piezoaktors zwischen den beiden den Piezoaktor begrenzenden peripheren Enden des Piezoaktors.

Der Temperatursensor kann unmittelbar im Aktorkern, also in einem zentralen Mittelpunkt des quer geschnittenen Piezoaktors angeordnet sein, oder in einem radial davon beabstandeten (Rand-)Bereich.

Entsprechend dem zuvor Erläuterten, kann auch im Inneren des Piezoaktors eine Anzahl von Temperatursensoren in unterschiedlichen Bereichen (entlang der Längserstreckung) des Piezoaktors angeordnet sein, z. B. in einem Fußbereich des Piezoaktors, im Zentralbereich des Piezoaktors sowie in einem Kopfbereich des Piezoaktors.

Besonders bevorzugt kann eine Anzahl von Temperatursensoren so im Gehäuse angeordnet sein, dass sich die jeweiligen Temperatursensoren, die in mehreren Bereichen der Innenwandung, der Aktoroberfläche sowie des Aktorkerns angeordnet sind, auf jeweils einer gemeinsamen gedachten Linie befinden. Vorzugsweise ergeben sich diese jeweiligen gemeinsamen Linien sowohl bei einer Draufsicht auf einen quer geschnittenen als auch auf einen längs geschnittenen Piezoaktor. Unter einem Längsschnitt wird dabei ein Schnitt entlang der Längserstreckung des Piezoaktors verstanden.

Grundsätzlich sind die Temperatursensoren dazu ausgebildet, die jeweils erfassten Messwerte, vorzugsweise mittels Temperatursensor-Anschlusskabel, selbstständig bzw. unaufgefordert im Wesentlichen in Echtzeit an eine Steuereinheit des Dosiersystems zu übertragen. Mittels der Steuereinheit kann eine Auswertung, Darstellung und/oder Speicherung der Messwerte erfolgen. Besonders bevorzugt kann aber in Abhängigkeit der zugeführten Temperatur-Messwerte mittels der Steuereinheit auch eine Regelung des Betriebs des Dosiersystems erfolgen, wie im Folgenden erläutert wird.

Grundsätzlich bringt die hermetische Kapselung des Piezoaktors im Dosiersystem eine Reihe von Vorteilen für den Betrieb des Dosiersystems mit sich. Zwar ist der grundsätzliche Aufbau von gekapselten Piezoaktoren bereits bekannt, z. B. aus der EP 1 419 539 B1, jedoch nicht für eine Nutzung in Dosiersystemen der eingangs genannten Art.

Aufgrund der hochfeinen Dosierungsauflösung, die von einem Dosiersystem üblicherweise gefordert wird, kann sich das Innere des Gehäuses in Folge der hochfrequenten Expansion des Piezoaktors und der damit einhergehenden Wärmeproduktion in Extremfällen - bei z. B. besonders hoher Arbeitsfrequenz bzw. Dosierfrequenz (Frequenz der Dosierstoffabgabe bzw. Tröpfchen) der Dosiersysteme - stark aufheizen. Unter Umständen kann dann die produzierte Wärme nicht ohne weiteres schnell genug von dem gekapselten Piezoaktor abgeführt werden. Um die Vorteile eines gekapselten Piezoaktors in dem Dosiersystem auch in Extremfällen nutzen zu können ist es vorteilhaft, den Piezoaktor durch zusätzliche Maßnahmen vor einer Überhitzung zu schützen. Es hat sich daher als besonders vorteilhaft herausgestellt, die Temperatur in den kritischen Bereichen des Aktors, insbesondere im Aktorkern, im Betrieb des Dosiersystems kontinuierlich zu überwachen, um so einer sich möglicherweise anbahnenden Überhitzung des Piezoaktors frühzeitig entgegenwirken zu können.

Dazu kann zumindest ein Temperatur-Messwert (Betriebsparameter) aus dem Inneren des Gehäuses und/oder eines Bereichs der äußeren Oberfläche (Außenseite) des Gehäuses, vorzugsweise eine Mehrzahl von Temperatur-Messwerten unterschiedlicher Bereiche des Gehäuses, der Steuereinheit als Temperatur-Istwert zugeführt werden. In Abhängigkeit des zugeführten Temperatur-Messwerts (Istwert) kann der Betrieb des Dosiersystems mittels der Steuereinheit so geregelt werden, dass ein vorgebbarer Sollwert der Temperatur in diesem bestimmten Bereich, insbesondere im Inneren des gekapselten Piezoaktors, erreicht bzw. nicht überschritten wird. Um eine aktive Regulierung der Temperatur (Temperaturmanagement) im Gehäuse bzw. des eingekapselten Piezoaktors zu erreichen, kann die Steuereinheit die Kühlleistung einer Kühleinrichtung des Dosiersystems regeln, wie später noch ausgeführt wird.

Je nach Anwendungsgebiet des Dosiersystems könnte mittels der Steuereinheit der Betrieb des Dosiersystems auch so geregelt werden, dass eine die Dosierfrequenz vorübergehend reduziert wird, wobei die Wärmeproduktion durch den Piezoaktor um einem bestimmten Grad verringert wird.

Alternativ oder zusätzlich kann in Abhängigkeit des Temperatur-Messwerts die Beschaltung bzw. Ansteuerung des gekapselten Piezoaktors mittels der Steuereinheit geregelt werden, um eine temperaturbedingte Längenänderungen des (erwärmten) Piezoaktors zu kompensieren und so eine stets möglichst exakte Dosierstoffabgabe zu erreichen. Durch einen Abgleich des Temperatur-Messwerts, welcher vorzugsweise einer Temperatur im Aktorkern entspricht, mit einem vorgebbaren Korrekturwert (z. B. ein aktorspezifischer temperaturabhängiger Expansionkoeffizient) kann die temperaturbedingte Längenänderung des (erwärmten) Piezoaktors durch die Steuereinheit bei der Beschaltung berücksichtigt werden, so dass z. B. die Spannung bei der Kontaktierung entsprechend reduziert oder vergrößert wird.

Um ein möglichst effizientes Temperaturmanagement des gekapselten Piezoaktors zu erreichen, kann im Gehäuse, d. h. in einem Zwischenraum zwischen der Innenwandung des Gehäuses und einer äußeren Oberfläche des gekapselten Aktors (Aktoroberfläche), ein wärmeleitendes Medium angeordnet sein. Bevorzugt ist das wärmeleitende Medium zur Ableitung bzw. Abfuhr von Wärme von der Aktoroberfläche ausgebildet.

Besonders bevorzugt kann das wärmeleitende Medium so ausgebildet sein, dass Wärme von der Aktoroberfläche mittels Konduktion an einen Bereich des Gehäuses übertragen wird. Alternativ kann das wärmeleitende Medium dazu ausgebildet sein, Wärme von der Aktoroberfläche mittels Konvektion in einen Bereich bzw. Abschnitt des Gehäuses zu transportieren. Besonders bevorzugt kann dazu ein überwiegend flüssiges wärmeleitendes Medium verwendet werden.

Vorzugsweise kann das wärmeleitende Medium eine Temperatur- bzw. Hitzebeständigkeit aufweisen, welche oberhalb von typischerweise im Betrieb des Dosiersystems an der Oberfläche des Piezoaktors auftretenden Temperaturen liegt. Vorzugsweise sollte das wärmeleitende Medium zumindest bis zu einer Temperatur von 140°C, besonders bevorzugt bis zu wenigstens 150°C, insbesondere bis zu wenigstens 160°C hitzestabil sein.

Grundsätzlich wäre es auch möglich, die Wärmeabfuhr von der Aktoroberfläche nach der Art eines Wärmerohrs ("Heat pipe") zu realisieren. Entsprechend könnte im hermetisch verkapselten Gehäuse (dem Wärmerohr) ein (wärmeleitendes) Medium angeordnet sein, welches Medium zu einem kleineren Teil im flüssigen und zu einem größeren Teil in einem dampfförmigen Zustand im Gehäuse vorliegt. Die Aktoroberfläche könnte dann eine entsprechende Wärmeübertragungsfläche für Wärmequelle darstellen, wobei ein vorgebbarer Bereich des Gehäuses als Wärmeübertragungsfläche für Wärmesenke ausgebildet sein könnte. Auf die Ausbildung einer bevorzugten "Wärmesenke" in einem Bereich des Gehäuses wird zu einem späteren Zeitpunkt noch genauer eingegangen.

Ungeachtet der konkreten Ausgestaltung ist das wärmeleitende Medium vorzugsweise als Teil einer im Inneren des Gehäuses angeordneten "Atmosphäre" realisiert. Bevorzugt ist die "Atmosphäre" derart beschaffen, dass sich für den Betrieb bzw. die Funktionsfähigkeit des gekapselten Piezoaktors besonders vorteilhafte Bedingungen im Gehäuse ergeben. Unter der "Atmosphäre" wird im Rahmen der Erfindung erweitert ein den Innenraum des Gehäuses im Wesentlichen vollständig ausfüllendes Medium verstanden, wobei der Innenraum zwischen einer äußeren, dem Innenraum zugewandten, Oberfläche des Piezoaktors, also der Aktoroberfläche, und der Innenwandung des Gehäuses ausgebildet ist. Die Atmosphäre umgibt bzw. umhüllt die Aktoroberfläche somit überwiegend vollständig und könnte daher auch als Umgebungsmedium bezeichnet werden. Vorzugsweise kann die Atmosphäre ein Gemisch verschiedenartiger gasförmiger, flüssiger und/oder fester Medien umfassen.

Um eine möglichst effiziente Ableitung der Wärme von der Aktoroberfläche zu erreichen, umfasst das Gehäuse einen definierten Wärmeabgabebereich . Der Wärmeabgabebereich ist wärmetechnisch mit einer Kühleinrichtung des Dosiersystems gekoppelt.

Unter einem Wärmeabgabebereich wird hier ein Bereich verstanden, der eine Wärmesenke zur Umgebung hin bildet. Mit anderen Worten stellt der Wärmeabgabebereich eine Wärmeübertragungsfläche für Wärmesenke dar. Der Wärmeabgabebereich kann neben einem Bereich einer äußeren Oberfläche des Gehäuses auch den entsprechenden Bereich der Innenwandung des Gehäuses sowie dazwischenliegende Bereiche des Gehäuses umfassen, z. B. den Metallkörper.

Vorzugsweise ist der Wärmeabgabebereich dazu ausgebildet, die vom Piezoaktor erzeugte Prozesswärme über das Gehäuse nach außen hin, also in einen das Gehäuse von außen umgebenden Bereich des Dosiersystems, abzugeben. Insbesondere in einem Zusammenspiel mit der Kühleinrichtung des Dosiersystems kann mittels des Wärmeabgabebereichs eine Regulierung der Temperatur im Gehäuse, insbesondere auch im Aktorkern, erreicht werden. Beispielsweise kann durch eine verstärkte Kühlung mittels der Kühleinrichtung die Menge an abgegebener Wärme im Wärmeabgabebereich erhöht werden, so dass in weiterer Folge auch mehr Wärme von der Aktoroberfläche abgeführt wird.

Vorzugsweise ist der Wärmeabgabebereich derart ausgestaltet und im oder am Gehäuse bzw. als Teil des Gehäuses angeordnet, dass eine möglichst effektive Abführung von Wärme aus dem Wärmeabgabebereich mittels der Kühleinrichtung erreicht wird. Beispielsweise könnte der Wärmeabgabebereich mittels einer Anzahl von Kühlrippen oder anderen Elementen zur Oberflächenvergrößerung in einem Bereich bzw. Abschnitt des Gehäusemantels realisiert sein. Der Wärmeabgabebereich kann daher nur partiell ausgebildet sein, d. h. er kann lediglich einen begrenzten Teilbereich des Gehäuses umfassen.

Die mit dem Wärmeabgabebereich zusammenwirkende Kühleinrichtung nutzt bevorzugt ein das Gehäuse von außen umströmendes Kühlmittel, welches ein gasförmiges und/oder flüssiges Medium umfassen kann. Vorzugsweise kann zumindest der Wärmeabgabereich, gegebenenfalls auch die gesamte Aktoreinheit, von dem Kühlmittel umströmt sein, wobei das Kühlmittel eine Mischung verschiedener Kühlsubstanzen umfassen kann.

Grundsätzlich ist das Kühlmittel dazu ausgebildet, die Wärme vom Wärmeabgabebereich zu einem Ort geringerer Temperatur wegzuführen. Dazu kann einer das Gehäuse des Piezoaktors umgebenden Kammer (Aktorkammer) des Dosiersystems kontinuierlich ein, insbesondere gasförmiges, Kühlmittel, z. B. Umgebungsluft, von außen zugeführt werden, so dass das Kühlmittel im Wesentlichen die gesamte Aktorkammer durchströmen kann. Bevorzugt kann Druckluft bzw. Pressluft, also in herkömmlicher Weise komprimierte Raumluft, als Kühlmittel verwendet werden, da in den meisten Anlagen ohnehin Pressluft zur Verfügung steht. Der Wärmeabgabebereich bzw. das Gehäuse fungieren dabei als eine Art Wärmetauscher: Die vom Piezoaktor erzeugte und an das Gehäuse, vorzugsweise den Wärmeabgabebereich, übertragene Wärme wird an das Kühlmittel übertragen bzw. mittels des Kühlmittels vom Gehäuse weggeführt.

Vorzugsweise kann das Dosiersystem zumindest jeweils eine Zuführ- bzw. Abführöffnung für das Kühlmittel umfassen. Bevorzugt kann sich ausgehend von der Zuführöffnung des Dosiersystems ein kühlmittelleitender Kanal, welcher auch als Zuströmkanal bezeichnet wird, überwiegend parallel zur Aktoreinheit im Gehäuse des Dosiersystems erstrecken, welcher in seinem Verlauf in eine Anzahl von im Wesentlichen rechtwinkligen kanalartigen kühlmittelleitenden Abzweigungen umfasst. Jede dieser Abzweigungen wird vom Zuströmkanal weg so durch das Gehäuse des Dosiersystems geführt, dass die jeweilige Abzweigung eine jeweilige Zuführöffnung in die Aktorkammer für das Kühlmittel ausbildet, d. h. eine einzelne Zuführöffnung des Dosiersystems kann mit einer Mehrzahl von Zuführöffnungen der Aktorkammer zusammenwirken.

Bevorzugt kann zur Regulierung der Kühlleistung der Kühleinrichtung (und damit auch zur Regulierung einer Temperatur im Gehäuse) das der Aktorkammer zeitlich zugeführte Volumen des Kühlmittels (aktiv) mittels der Steuereinheit reguliert werden, z. B. in Abhängigkeit einer Temperatur im Gehäuse. Vorzugsweise kann dazu zumindest an der Zuführöffnung des Dosiersystems eine von der Steuereinheit (vorzugsweise mit einer Regeleinheit) ansteuerbare "Kühlmittelzuführvorrichtung", z. B. eine Pumpe, angeordnet sein, um den Kühlmitteleinstrom in die Aktorkammer (aktiv) zu regulieren, so dass ein vorgebbarer Sollwert der Temperatur in einem bestimmten Bereich des Gehäuses erreicht wird. Alternativ kann eine aus einem Kompressor oder Pressluftreservoir zugeführte Menge an Druckluft mittels eines Proportionalventils durch die Steuereinheit geregelt werden.

Bevorzugt kann das Kühlmittel in der Aktorkammer gezielt zum Wärmeabgabebereich des Gehäuses gelenkt werden. Besonders bevorzugt kann einer jeweiligen Zuführöffnung der Aktorkammer eine jeweils damit zusammenwirkende Abführöffnung zugeordnet sein, wobei die jeweiligen Zuführ- bzw. Abführöffnungen so zueinander und zum Wärmeabgabebereich positioniert sind, dass das einströmende Kühlmittel auf seinem Weg von einer jeweiligen Zuführöffnung zur jeweils damit zusammenwirkenden Abführöffnung erzwungenermaßen zumindest einen Teilbereich des Wärmeabgabebereichs umströmt. Vorzugsweise können sich die einzelnen Abführöffnungen der Aktorkammer zu einem gemeinsamen Ausströmkanal vereinigen, welcher analog zum Zuströmkanal ausgebildet sein kann.

Alternativ könnte die Aktorkammer auch nur jeweils eine einzige Zuführ- bzw. Abführöffnung für das Kühlmittel umfassen, d. h. die Zuführ- bzw. Abführöffnung der Aktorkammer entspricht gleichzeitig der Zuführ- bzw. Abführöffnung des Dosiersystems. Vorzugsweise können in der Aktorkammer "strömungslenkende" Elemente angeordnet sein, z. B. Leitbleche oder Lüfter, um das einströmende Kühlmittel möglichst direkt bzw. gerichtet von einer Zuführöffnung der Aktorkammer zum Wärmeabgabebereich und anschließend zu einer Abführöffnung der Aktorkammer zu leiten. Alternativ oder zusätzlich könnte das Kühlmittel auch für eine bestimmte Zeitspanne in der Aktorkammer umgewälzt werden, d. h. ohne Zustrom von neuem Kühlmittel in die Aktorkammer, soweit damit eine ausreichende Kühlleistung erreicht wird.

In Abhängigkeit der Beschaffenheit des Kühlmittels sowie der im Kühlmittel bzw. im Gehäuse vorherrschenden Bedingungen, insbesondere hinsichtlich der Temperatur und dem auf das Kühlmittel ausgeübten Druck, kann das Kühlmittel auch überwiegend flüssig bzw. in Teilen flüssig und in Teilen gasförmig vorliegen.

Bevorzugt kann die Kühleinrichtung so ausgebildet sein, dass mechanischer Abrieb, der sich z. B. in Folge der Expansionsbewegung des Gehäuses bzw. anderer beweglicher Teile in der Aktorkammer ergibt, durch das Kühlmittel aus der Aktorkammer in einen Bereich außerhalb der Aktorkammer, vorzugsweise außerhalb des Dosiersystems, weggeführt wird.

Vorteilhafterweise kann durch ein effizientes Temperaturmanagement des eingekapselten Piezoaktors eine unterbrechungsfreie Einsatzdauer des Dosiersystems deutlich erhöht werden. Die einzelnen am Temperaturmanagement beteiligten Komponenten bilden, insbesondere in einem Zusammenspiel, ein effektives Temperaturmanagement-System und ermöglichen, dass eine sich anbahnende Überhitzung des Piezoaktors nicht nur frühzeitig erkannt, sondern vorteilhafterweise auch verhindert werden kann. Mittels des Temperaturmanagement-Systems sowie des darauf zugreifenden Verfahrens zum Betrieb des Dosiersystems kann die Temperatur des Piezoaktors während des Betriebs des Dosiersystems nahezu konstant in einem für die Langlebigkeit des Piezoaktors vorteilhaften Bereich gehalten werden.

Weiterhin vorteilhaft ist, dass mittels des Temperaturmanagement-Systems auch die Präzision des Dosiersystems verbessert werden kann. Unter Umständen kann sich das temperaturabhängige Ausdehnungsverhalten des gekapselten Piezoaktors nachteilig auf die Genauigkeit der Dosierstoffabgabe des Dosiersystems auswirken, z. B. wenn das Ausstoßelement aufgrund einer veränderten Länge (Längsausdehnung) des Piezoaktors die Düse nicht mehr zuverlässig verschließen kann. Vorteilhafterweise kann mittels des Temperaturmanagement-Systems die Temperatur des Piezoaktors auf einem bestimmten Sollwert gehalten werden, so dass der Piezoaktor im Betrieb des Dosiersystem im Wesentlichen eine konstante Länge aufweist, wobei die Präzision des Dosiersystems deutlich erhöht werden kann.

Lediglich der Vollständigkeit halber sei darauf hingewiesen, dass die Wärmeabfuhr aus dem Wärmeabgabebereich, also die Kühlung des gekapselten Piezoaktors, auch zumindest teilweise durch "natürliche" Konvektion mittels der die Aktoreinheit umgebenden Luft erfolgen kann. Bei dieser Art der "passiven" Kühlung ist folglich kein gezieltes Temperaturmanagement des Piezoaktors möglich, so dass die zuvor erläuterte aktive TemperaturRegulierung bevorzugt ist.

Um im Rahmen des Temperaturmanagements den Betrieb des Dosiersystems in Abhängigkeit einer Temperatur im Gehäuse zu ermöglichen, sollte zumindest ein Temperatur-Messwert nach außen zur Steuereinheit geführt werden. Vorzugsweise umfasst das Gehäuse daher zumindest eine Durchführung für eine Anzahl von elektrischen Leitern bzw. Leiterbahnen. Bevorzugt umfasst das Gehäuse zumindest zwei separate Durchführungen, weiter bevorzugt zumindest drei separate Durchführungen, besonders bevorzugt zumindest vier separate Durchführungen zur Durchführung von jeweils zumindest einem elektrischen Leiter.

Besonders bevorzugt sind die Durchführungen so ausgebildet und angeordnet, dass der jeweilige elektrische Leiter hermetisch dicht und elektrisch isoliert zwischen dem Innenraum bzw. Innenbereich des Gehäuses und einem das Gehäuse umgebenden Äußeren bzw. Außenbereich des Gehäuses verläuft.

Vorzugsweise sind zumindest zwei der elektrischen Leiter zur Kommunikation mit der Steuereinheit ausgebildet, d. h. es werden Steuersignale zur Steuerung des gekapselten Piezoaktors von der Steuereinheit an den Piezoaktor übertragen. Der Piezoaktor kann dazu z. B. zwei Kontaktstellen bzw. Anschlusspole aufweisen, wobei jeweils ein Anschlusspol mit einer Gruppe der parallel geschalteten Innenelektroden des Piezoaktors gekoppelt ist. Vorzugsweise ist ein jeweiliger Anschlusspol des Piezoaktors fest mit jeweils einem der beiden durchgeführten elektrischen Leiter verbunden, z. B. verlötet. Zwei weitere elektrische Leiter sind vorzugsweise dazu ausgebildet, eine Anzahl von Temperatursensoren im Gehäuse zu kontaktieren bzw. entsprechende Temperatur-Messwerte an die Steuereinheit zu übertragen. Beispielsweise könnte ein einzelner PT100 Temperaturfühler mittels der beiden durchgeführten elektrischen Leiter kontaktiert werden. Alternativ könnte auch eine Mehrzahl von (busfähigen) Temperaturmess-ICs bzw. IC-Temperaturfühlern mittels der beiden durchgeführten elektrischen Leiter kontaktiert werden. Sofern eine Mehrzahl von PT100 Temperaturfühlern im Gehäuse angeordnet ist, könnte jeder einzelne dieser Temperaturfühler mittels zwei separaten, also einem jeweiligen Temperaturfühler zugeordneten, durchgeführten elektrischen Leitern kontaktiert werden.

Bevorzugt können die elektrischen Leiter mittels elektrischer Stecker bzw. Anschlussstifte realisiert sein. Vorzugsweise erfolgt die Durchführung eines jeweiligen Steckers durch das Gehäuse mittels jeweils eines fest in das Gehäuse integrierten Glaslots. Bevorzugt können die jeweiligen Glaslote bzw. Glasdurchführungen in den Gehäuseboden und/oder Gehäusedeckel eingebracht sein. Besonders bevorzugt werden die elektrischen Stecker bzw. Leiter mittels Glaslot hermetisch dicht und elektrisch isoliert vom Inneren des Gehäuses nach außen geführt.

Es sei an dieser Stelle darauf hingewiesen, dass die Kontaktierung des gekapselten Piezoaktors bzw. der Temperatursensoren im Gehäuse mittels der Durchführungen auch auf eine andere als die zuvor erläuterte Weise erfolgen kann. Beispielsweise könnte zumindest ein Temperatursensor mit einem Kontakt (Anschlusspol) des Piezoaktors verbunden sein, so dass lediglich drei Durchführungen benötigt würden. Zusätzlich könnte eine weitere Durchführung (z. B. zur Weiterleitung eines Messsignals des Temperatursensors) dadurch eingespart werden, dass das Potential des zugehörigen elektrischen Leiters auf das metallische Gehäuse gelegt wird und so von außen abgreifbar ist. Es wäre aber auch denkbar, dass die Temperatur-Messwerte (Sensorsignale) zumindest eines Temperatursensors auf die Anschlussstifte bzw. Anschlüsse des gekapselten Piezoaktors gelegt und auf diese in geeigneter Weise moduliert werden, wie dies z. B. bei der Einrichtung einer "PowerLan" bzw. "direct Lan" Verbindung erfolgt. Das (Auf-)Modulieren der Sensorsignale könnte auch so erfolgen, dass die Temperatur-Messwerte einer Mehrzahl von Temperatursensoren (z. B. busfähige Temperaturmess-ICs) an die Steuereinheit übertragen werden könnten oder die gesammelten Temperatur-Messwerte einer Mehrzahl von Temperatursensoren als ein Datenstrom übermittelt werden könnten. Sofern das metallische Gehäuse, wie zuvor erwähnt, als Kontaktelement genutzt würde, könnte die Kontaktierung des Piezoaktors sowie einer Anzahl von Temperatursensoren dann mittels nur einer einzigen Durchführung erfolgen. Dennoch wird im Folgenden von einem Gehäuse mit vier separaten Durchführungen ausgegangen, ohne die Erfindung darauf zu beschränken.

Bevorzugt kann ein durchgeführter elektrischer Leiter jeweils auch eine mehradrige Leitung zur Leitung elektrischer Signale umfassen. Auch damit ist es möglich, die einzelnen Messwerte (Messsignale) einer Mehrzahl von Temperatursensoren parallel an die Steuereinheit zu übertragen. Dazu könnte eine Mehrzahl von feinen Drähten gemeinsam durch eine einzelne Durchführung geleitet werden, wobei die einzelnen Drähte jeweils in einem geeigneten Abstand zueinander angeordnet und gemeinsam mit Glaslot vergossen sind. Eine derart ausgebildete Durchführung könnte auch als mehradrige Durchführung bezeichnet werden.

Vorteilhafterweise kann mittels der Durchführungen durch das Gehäuse des gekapselten Piezoaktors erreicht werden, dass die Ansteuerung des gekapselten Piezoaktors wie bei einem herkömmlichen Dosiersystem mit einem ungekapselten Piezoaktor erfolgen kann, d. h. es können auch Steuereinheiten herkömmlicher Dosiersysteme zur Ansteuerung des gekapselten Piezoaktors genutzt werden. Weiterhin kann mittels der durchgeführten Temperatur-Messwerte eine Steuerung des Betriebs des Dosiersystems in Abhängigkeit einer Temperatur im Gehäuse erfolgen.

Um die Langlebigkeit des gekapselten Piezoaktors weiter zu erhöhen, kann im Inneren des Gehäuses, also in einem Bereich zwischen der Innenwandung des Gehäuses und der Oberfläche des Aktors, ein Medium zur Feuchtigkeitsunterdrückung angeordnet sein. Vorzugsweise erfolgt die Feuchtigkeitsunterdrückung so, dass im Inneren des Gehäuses auftretende Feuchtigkeit (z. B. Wasser oder Wasserdampf) unmittelbar und im Wesentlichen vollständig gebunden und/oder umgewandelt wird. Vorzugsweise ist das feuchtigkeitsunterdrückende Medium dazu ausgebildet, die Aktoroberfläche zuverlässig vor einem Kontakt mit Feuchtigkeit abzuschirmen bzw. zu isolieren. Insbesondere kann mittels des feuchtigkeitsunterdrückenden Mediums das Maß an "verfügbarem" Wasser, das sich theoretisch an der Aktoroberfläche anlagern könnte, ausreichend dauerhaft, also zumindest für den Zeitraum einer typischen Verwendung des Piezoaktors in dem Dosiersystem, unterhalb eines für den Betrieb des Piezoaktors kritischen Grenzwerts gehalten werden.

Zur Feuchtigkeitsunterdrückung im Gehäuse kann das feuchtigkeitsunterdrückende Medium unterschiedliche flüssige und/oder feste Medien umfassen, welche Feuchtigkeit chemisch umwandeln bzw. reaktiv verbrauchen. Bevorzugt kann das feuchtigkeitsunterdrückende Medium zumindest ein wasserabsorbierendes bzw. hygroskopisches Medium umfassen, welches z. B. mittels eines Trockengels oder nach der Art eines Molekularsiebs realisiert sein kann. Alternativ oder zusätzlich kann das feuchtigkeitsunterdrückende Medium ein wassertransportierendes, elektrisch isolierendes Medium umfassen. Vorzugsweise kann dazu ein flüssiges wasserfreies und wasserleitendes Isoliermedium verwendet werden.

Vorzugsweise kann die Atmosphäre neben dem wärmleitenden bzw. feuchtigkeitsunterdrückenden Medium noch weitere, den unterbrechungsfreien Betrieb des Dosiersystems begünstigende Komponenten, umfassen.

Bevorzugt kann die Atmosphäre des Gehäuses einen Druckausgleichsbereich umfassen. Der Druckausgleichsbereich, welcher auch als Expansionsbereich bezeichnet werden könnte, stellt im Gehäuse ein bestimmtes Volumen zum Ausgleich von thermischer Expansion des Piezoaktors bereit. Vorzugsweise ist der Expansionsbereich mittels eines Gases oder Gasgemisches realisiert, welches eine hohe Kompressibilität aufweist. Grundsätzlich kann das Medium, das den Expansionsbereich ausbildet, in der Atmosphäre frei beweglich angeordnet sein. Beispielsweise könnte die Atmosphäre ein flüssiges und/oder festes feuchtigkeitsunterdrückendes und/oder wärmeleitendes Medium sowie einen gasförmig ausgebildeten Expansionsbereich, z. B. eine Gasblase umfassen. Alternativ könnte der Expansionsbereich in einem abgeschlossenen bzw. umschlossenen Bereich mit einer zumindest teilweise flexiblen Hülle oder Trennwand vom restlichen Bereich des Innenraums des Gehäuses abgetrennt im Gehäuse angeordnet sein, also stofflich von der übrigen Atmosphäre getrennt.

Vorteilhafterweise ist der Druckausgleichsbereich so ausgestaltet, dass eine im typischen Betrieb des Dosiersystems auftretende temperaturbedingte Volumenänderung des Piezoaktors so kompensiert werden kann, dass ein vorgebbarer Druck im Inneren des Gehäuses (Innendruck) auch während des Betriebs des Dosiersystems im Wesentlichen konstant bleibt. Durch die Anordnung einer definierten Atmosphäre im Gehäuse kann also sowohl die unterbrechungsfreie Einsatzdauer als auch die Präzision des Dosiersystems verbessert werden.

Um den Innendruck im Betrieb des Dosiersystems kontinuierlich überwachen zu können, kann im Gehäuse zumindest ein Drucksensor zur Messung des Innendrucks angeordnet sein. Vorzugsweise kann zumindest ein Druck-Messwert der Steuereinheit als Druck-Istwert zugeführt werden, wie dies bereits analog für die Temperatur-Messwerte beschrieben wurde. Bevorzugt kann auch in Abhängigkeit des zugeführten Druck-Messwerts der Betrieb des Dosiersystems mittels der Steuereinheit so geregelt werden, dass ein vorgebbarer Druck-Sollwert im Gehäuse nicht überschritten wird. Dazu könnte der Druck-Istwert im Rahmen des zuvor erläuterten Temperaturmanagements berücksichtigt werden, d. h. mittels des Temperaturmanagements kann eine Temperatur und/oder ein Druck im Gehäuse reguliert werden.

Zusätzlich oder auch alternativ zu den bereits genannten Detektionsmöglichkeiten kann im Inneren des Gehäuses (z. B. im Bereich der Gehäuse-Innenwandung) und/oder auf einer Außenseite des Gehäuses zumindest ein so genannter Dehnmessstreifen zur Überwachung der absoluten Länge und der dynamischen Längenänderung des gekapselten Piezoaktors oder der gesamten Aktoreinheit angebracht sein. Sofern ein Dehnmessstreifen im Gehäuse angeordnet ist, können die entsprechenden Messsignale mittels einer zuvor erläuterten Durchführung durch das Gehäuse zur Steuereinheit geführt werden. Das so gewonnene Signal kann Rückschlüsse über den jeweiligen Betriebszustand des Piezoaktors bzw. der Aktoreinheit liefern und kann somit auch für entsprechende Kompensationsmaßnahmen, etwa einen angepassten Kühlmittelstrom oder eine veränderte Ansteuerspannung, genutzt werden.

Bevorzugt kann das den piezokeramischen Aktor umgebende Gehäuse eine vorgebbare mechanische Vorspannung auf den piezokeramischen Aktor ausüben. Wie eingangs erläutert ist der (ruhende) Piezoaktor so in dem Gehäuse angeordnet, dass die beiden peripheren Endbereiche direkten Kontakt zum Gehäuseboden bzw. -deckel haben. Vorzugsweise kann das Gehäuse derart bemessen und ausgebildet sein, dass es einen bestimmten Druck auf den (ruhenden) Piezoaktor ausübt bzw. eine Kompression desselben bewirkt.

Vorteilhafterweise kann dadurch erreicht werden, dass der Piezoaktor im ruhenden Zustand bereits mechanisch vorgespannt ist, was bei einer dynamischen Belastung des Piezoaktors eine erhöhte Sicherheit gegen Zugbelastungen im piezoelektrischen Material darstellt, wobei die Ausfallwahrscheinlichkeit des Dosiersystems weiter verringert wird. Entsprechend kann der Aufbau des Dosiersystems vereinfacht werden, da auf die Anordnung von Komponenten (z. B. Aktorfeder), welche bei herkömmlichen Dosiersystemen der Rückführung des ungekapselten Piezoaktors in seinen Ruhezustand dienen, verzichtet werden kann oder diese zumindest schwächer ausgelegt werden können.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine im Schnitt dargestellte Ansicht einer Ausführungsform eines erfindungsgemäßen Dosiersystems,
Figuren 2 und 3 Teile einer im Schnitt dargestellten anderen Ausführungsform eines erfindungsgemäßen Dosiersystems,
Figuren 4 und 5 Schnittansichten von unterschiedlichen möglichen Ausführungsformen von Aktoreinheiten für ein erfindungsgemäßes Dosiersystem,
Figur 6 eine perspektivische Ansicht einer weiteren möglichen Ausführungsform einer Aktoreinheit für ein erfindungsgemäßes Dosiersystem.

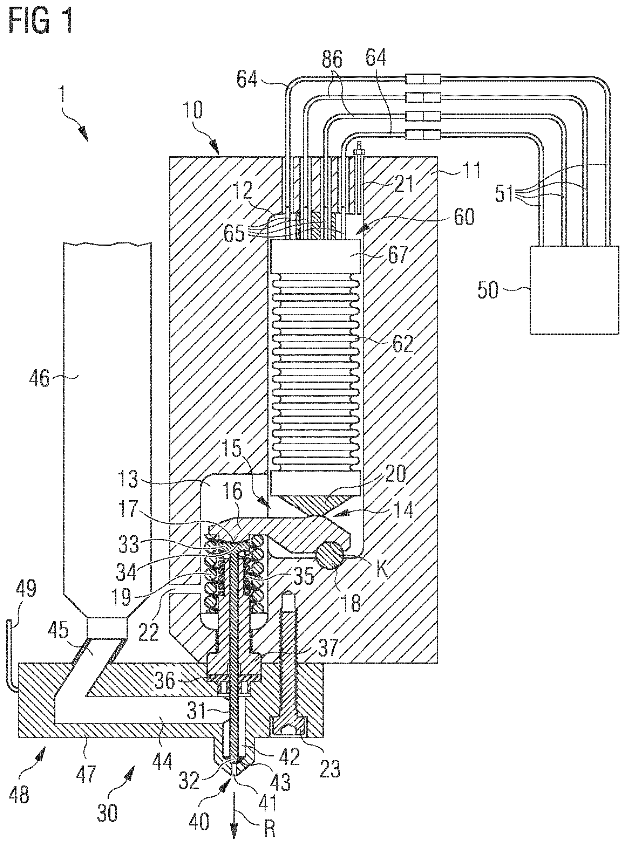

Anhand der Figur 1 wird nun ein konkretes bevorzugtes Ausführungsbeispiel eines erfindungsgemäßen Dosiersystems 1 beschrieben. Das Dosiersystem 1 wird hier in der üblichen bestimmungsgemäßen Lage bzw. Position dargestellt, z. B im Betrieb des Dosiersystems 1. Dabei befindet sich eine Düse 40 im unteren Bereich des Dosiersystems 1, sodass die Tropfen des Mediums in einer Ausstoßrichtung R durch die Düse 40 nach unten ausgestoßen werden. Soweit im Folgenden die Begriffe unten und oben verwendet werden, beziehen sich diese Angaben daher immer auf eine solche, meist übliche Position des Dosiersystems 1. Dies schließt aber nicht aus, dass das Dosiersystem 1 in speziellen Anwendungen auch in einer anderen Position eingesetzt werden kann und die Tropfen beispielsweise seitlich ausgestoßen werden. Je nach Medium, Druck und genauer Konstruktion sowie Ansteuerung des gesamten Ausstoßsystems ist dies grundsätzlich auch möglich.

Das Dosiersystem 1 umfasst als wesentliche Komponenten eine Aktor-Baugruppe 10 sowie eine Fluidik-Baugruppe 30. In dem hier gezeigten Ausführungsbeispiel des Dosiersystems 1 sind die Aktor-Baugruppe 10 und die Fluidik-Baugruppe 30 fest miteinander verbunden, z. B. mittels einer Fixierschraube 23. Es sei jedoch darauf hingewiesen, dass die jeweiligen Baugruppen 10, 30 auch nach der Art von miteinander verkoppelbaren Stecckupplungsteilen zur Ausbildung einer Schnellkupplung realisiert sein können. Entsprechend könnten die Aktor-Baugruppe 10 und die Fluidik-Baugruppe 30 werkzeuglos miteinander verkuppelt werden, um so das Dosiersystems 1 auszubilden.

Die Aktor-Baugruppe 10 umfasst im Wesentlichen alle Komponenten, die für den Antrieb bzw. die Bewegung eines Ausstoßelements 31 in der Düse 40 sorgen, also z. B. die Aktoreinheit 60, eine Bewegungsmechanik, um das Ausstoßelement 31 der Fluidik-Baugruppe 30 betätigen zu können, eine Steuereinheit 50, um einen Piezoaktor 61 ansteuern zu können und ähnliche Komponenten, wie nachfolgend noch erläutert wird.

Die Fluidik-Baugruppe 30 umfasst neben der Düse 40 und der Zuleitung 44 des Mediums zur Düse 40 alle weiteren Teile, die direkt mit dem Medium in Kontakt stehen, sowie außerdem die Elemente, die erforderlich sind, um die betreffenden, mit dem Medium in Kontakt stehenden Teile zusammen zu montieren bzw. in ihrer Position an der Fluidik-Baugruppe 30 zu halten.

In dem hier gezeigten Ausführungsbeispiel des Dosiersystems 1 umfasst die Aktor-Baugruppe 10 einen Gehäuseblock 11 mit zwei innenliegenden Kammern, nämlich zum einen eine Aktorkammer 12 mit einer darin befindlichen Aktoreinheit 60 mit zumindest einem in ein Gehäuse 62 eingekapselten piezokeramischen Aktor (hier nicht sichtbar), und zum anderen eine Aktionskammer 13, in welche ein bewegliches Ausstoßelement 31, hier ein Stößel 31, der Fluidik-Baugruppe 30 hineinragt. Über einen Bewegungsmechanismus 14, welcher von der Aktorkammer 12 in die Aktionskammer 13 hineinragt, wird mittels der Aktoreinheit 60 der Stößel 31 so betätigt, dass von der Fluidik-Baugruppe 30 das zu dosierende Medium in der gewünschten Menge zum gewünschten Zeitpunkt ausgestoßen wird. Der Stößel 31 verschließt hier - wie später noch erläutert wird - eine Düsenöffnung 41 und dient somit auch als Verschlusselement 31. Da aber der größte Teil des Mediums erst aus der Düsenöffnung 41 ausgestoßen wird, wenn der Stößel 31 sich in der Schließrichtung bewegt, wird er hier als Ausstoßelement 31 bezeichnet.

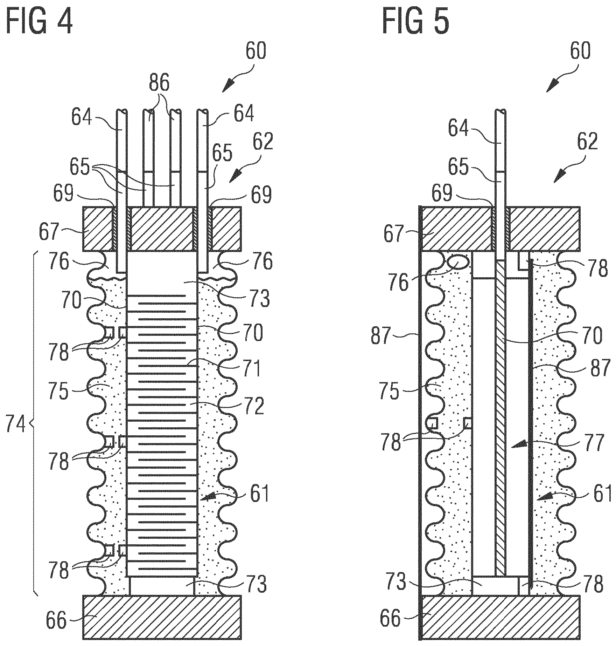

Zur Ansteuerung der Aktoreinheit 60 ist die Aktoreinheit 60 bzw. der im Gehäuse 62 angeordnete Piezoaktor (siehe Figur 4) elektrisch bzw. signaltechnisch mit einer Steuereinheit 50 des Dosiersystems 1 verbunden. Die Verbindung zu dieser Steuereinheit 50 erfolgt über Steuerkabel 51, welche endseitig mit geeigneten Aktoreinheit-Steueranschlüssen 64, z. B. geeigneten Steckern, verbunden sind. Anders als in Figur 1 dargestellt, können die Steueranschlüsse 64 abgedichtet so durch das Gehäuse 10 geführt werden, dass im Bereich der jeweiligen durchgeführten Steueranschlüsse 64 im Wesentlichen keine Luft von außen in die Aktorkammer 12 eindringen kann, z. B. im Rahmen einer nachfolgend beschriebenen Kühlung der Aktoreinheit 60 mit Pressluft. Die Aktoreinheit 60, insbesondere die Aktoreinheit-Steueranschlüsse 64, können beispielsweise mit einer geeigneten Speichereinheit (z.B. einem EEPROM oder dergleichen) versehen sein, in der Informationen wie eine Artikelbezeichnung etc. oder Regelparameter für die Aktoreinheit 60 hinterlegt sind, die dann von der Steuereinheit 50 ausgelesen werden können, um die Aktoreinheit 60 zu identifizieren und in der passenden Weise anzusteuern. Die Steuerkabel 51 können mehrere Steuerleitungen und Datenleitungen umfassen. Da die grundsätzliche Ansteuerung von Piezoaktoren aber bekannt ist, wird hierauf nicht weiter eingegangen.

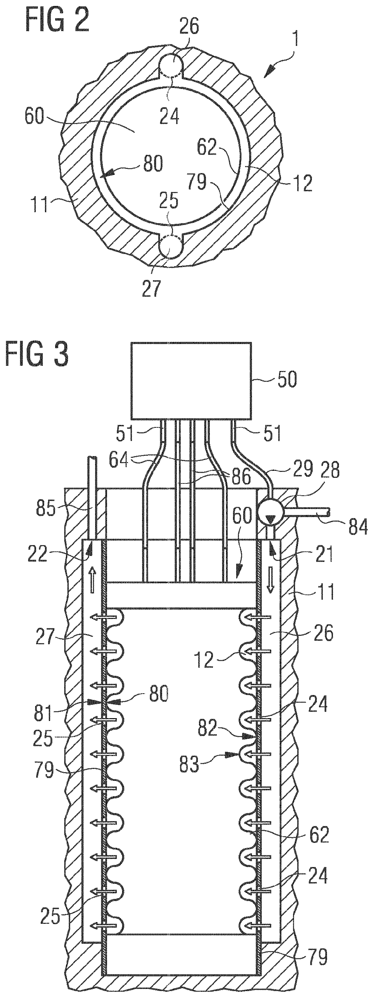

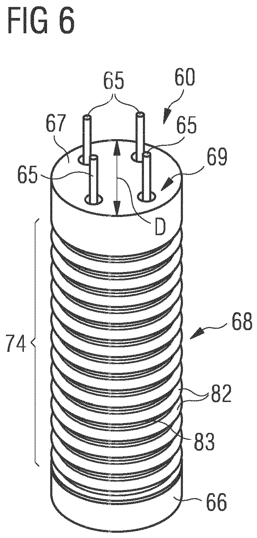

Zur hermetisch dichten und elektrisch isolierten Durchführung jeweils eines elektrischen Leiters durch das Gehäuse 62 umfasst die Aktoreinheit 60 in einem Gehäusedeckel 67 vier Kontaktstifte 65. Die Kontaktstifte 65 sind hier (wie auch in den Figuren 3 und 4) der Übersichtlichkeit wegen parallel bzw. in einer Reihe angeordnet, wobei die Kontaktstifte 65 auch in einer anderen geeigneten Anordnung realisiert sein können (siehe Figur 6). Die beiden hier äußeren Kontaktstifte 65 dienen der Ansteuerung des Piezoaktors bzw. der Kommunikation zwischen Piezoaktor und Steuereinheit 50. Außerhalb des Gehäuses 62 sind die Kontaktstifte 65 über jeweilige Aktoreinheit-Steueranschlüsse 64 mit der Steuereinheit 50 gekoppelt. Im Inneren des Gehäuses 62 ist jeweils ein Kontaktstift 65 mit einem der beiden Anschlusspole des Piezoaktors verbunden (siehe Figur 5). Die beiden hier mittig gezeigten Kontaktstifte 65 werden dazu genutzt, um die Messwerte von Temperatursensoren 78 (siehe Figur 4) aus dem Gehäuse 62 an die Steuereinheit 50 zu übertragen. Dazu sind die Kontaktstifte 65 jeweils einerseits mittels Temperatursensor-Anschlusskabeln 86 mit der Steuereinheit 50 und andererseits (im Gehäuse) mit den einzelnen Temperatursensoren 78 verbunden, vorzugsweise mittels jeweiliger Temperatursensor-Verbindungskabel (hier nicht gezeigt). Eine genaue Beschreibung der Kontaktierung der Temperatursensoren im Gehäuse wird zu einem späteren Zeitpunkt gegeben.

Der im Gehäuse 62 angeordnete Piezoaktor (siehe Figur 4) kann sich bzw. das Gehäuse 62 in Längsrichtung der Aktorkammer 12 entsprechend einer Beschaltung mittels der Steuereinrichtung 50 ausdehnen (expandieren) und wieder zusammenziehen. Die Aktoreinheit 60 kann von oben in die Aktorkammer 12 eingelegt werden. Als oberes Widerlager kann anschließend eine durch eine Schraubbewegung höhenverstellbare Kugelkalotte dienen (hier nicht gezeigt), wobei eine genaue Justage der Aktoreinheit 60 zu einem Bewegungsmechanismus 14, hier einem Hebel 16, ermöglicht wird. Entsprechend ist die Aktoreinheit 60 nach unten über ein unten spitzwinkelig zulaufendes Druckstück 20 auf dem Hebel 16 gelagert, welcher wiederum auf einem Hebellager 18 am unteren Ende der Aktorkammer 12 aufliegt. Über dieses Hebellager 18 ist der Hebel 16 um eine Kippachse K verkippbar, so dass ein Hebelarm des Hebels 16 durch einen Durchbruch 15 in die Aktionskammer 13 hineinragt. Am Ende des Hebelarms weist dieser eine in Richtung zum Stößel 31 der mit der Aktor-Baugruppe 10 gekoppelten Fluidik-Baugruppe 30 weisende Kontaktfläche 17 auf, welche auf die Kontaktfläche 34 des Stößelkopfs 33 drückt. Der Piezoaktor bzw. das Druckstück 20 einerseits und der Stößelkopf 33 bzw. ein Stößel 31 andererseits wirken auf derselben Seite des Hebels 16 bezogen auf die Kippachse K. Allerdings ist der jeweilige Abstand zwischen dem Piezoaktor und der Kippachse K bzw. zwischen dem Stößel 31 und der Kippachse K unterschiedlich.

Der Hebel 16 bzw. der Bewegungsmechanismus 14 stellt hier ein Übersetzungselement dar, um eine Auslenkung (Hub) des Stößels 31 gegenüber einem Hub des Piezoaktors in einem bestimmten Verhältnis zu vergrößern. Ein derartiges Übersetzungselement ist besonders zur Dosierung von Dosierstoffen mit einer mittleren oder hohen Viskosität vorteilhaft, wobei die Viskosität bis zu 0,5 Pa*s, vorzugsweise bis zu 1 Pa*s, besonders bevorzugt bis zu 1000 Pa*s betragen kann.

Es sei an dieser Stelle erwähnt, dass bei dem gezeigten Ausführungsbeispiel vorgesehen ist, dass die Kontaktfläche 17 des Hebels 16 permanent in Kontakt mit der Kontaktfläche 34 des Stößelkopfs 33 ist, indem eine Stößelfeder 35 den Stößelkopf 33 von unten gegen den Hebel 16 drückt. Grundsätzlich wäre es aber auch möglich, dass in einer Ausgangs- bzw. Ruhelage der Stößelfeder 35 ein Abstand zwischen Stößel 31 und Hebel 16 vorhanden ist, sodass der Hebel 16 zunächst bei einem Herunterschwenken frei einen bestimmten Wegabschnitt durchfährt und dabei Geschwindigkeit aufnimmt und dann mit einem hohem Impuls auf den Stößel 31 bzw. dessen Kontaktfläche 34 aufschlägt, um den Ausstoßimpuls zu erhöhen, den der Stößel 31 wiederum auf das Medium ausführt. Um eine nahezu konstante Vorspannung des Antriebssystems (Hebel-Aktoreinheit-Bewegungssystem) zu ermöglichen, wird der Hebel 16, an dem Ende, an dem er mit dem Stößel 31 in Kontakt kommt, durch eine Aktorfeder 19, nach oben gedrückt.

Im unteren Bereich umfasst die Aktionskammer 13 eine Abführöffnung 22 für ein Kühlmittel, z. B. komprimierte Umgebunsluft bzw. Pressluft. Die Abführöffnung 22 verläuft durch eine Kammerwandung der Aktionskammer 13 bzw. durch den Gehäuseblock 11 und zwar direkt, also unverzweigt, von einem Innenraum der Aktionskammer 13 zu einer Außenseite des Dosiersystems 1. Die Abführöffnung 22 entspricht in diesem Fall also gleichermaßen der Abführöffnung 22 der Aktionskammer 13 wie auch der Abführöffnung 22 des Dosiersystems 1.

Die Abführöffnung 22 kann im Zusammenspiel mit einer entsprechenden Zuführöffnung 21 des Dosiersystems 1 für das Kühlmittel im oberen Bereich der Aktorkammer 12 dazu genutzt werden, dass die Aktorkammer 12 und die Aktionskammer 13 kontinuierlich von Kühlmittel durchströmt werden. Vorzugsweise kann mittels des Kühlmittelstroms mechanischer Abrieb aus der Aktorkammer 12 bzw. Aktionskammer 13 durch die Abführöffnung 22 aus dem Dosiersystem 1 entfernt werden. Die Zuführöffnung 21 der Aktionskammer 12 entspricht hier gleichermaßen der Zuführöffnung 21 des Dosiersystems 1. In Figur 1 umfasst die Zuführöffnung 21 einen außenliegenden Stecknippel zur Kontaktierung eines Schlauchs zur Zuführung von Druckluft in die Aktorkammer 12.

Ein weiterer wesentlicher Aspekt des angesprochenen Kühlmittels ist die Kühlung des im Gehäuse 62 eingekapselten Piezoaktors bzw. der Aktoreinheit 60. Dies wird an anderer Stelle noch im Detail erläutert.

Die Fluidik-Baugruppe 30 ist hier wie erwähnt mittels einer Fixierschraube 23 mit der Aktor-Baugruppe 10 verbunden. Der Stößel 31 ist mittels der Stößelfeder 35 einem Stößellager 37 aufgelagert, an welches sich nach unten eine Stößeldichtung 36 anschließt. Die Stößelfeder 35 drückt den Stößelkopf 33 vom Stößellager 37 in axialer Richtung nach oben weg. Somit wird auch eine Stößelspitze 32 von einem Dichtsitz 43 der Düse 40 wegdrückt. D. h. ohne äußeren Druck von oben auf die Kontaktfläche 34 des Stößelkopfs 31 befindet sich in der Ruhelage der Stößelfeder 35 die Stößelspitze 32 in einem Abstand vom Dichtsitz 43 der Düse 40. Somit ist im Ruhezustand (nicht expandierten Zustand) des Piezoaktors auch eine Düsenöffnung 41 frei bzw. unverschlossen.

Die Zuführung des Dosierstoffs zur Düse 40 erfolgt über eine Düsenkammer 42 sowie einen sich daran anschließenden Zuführkanal 44. Der Zuführkanal 44 ist mittels einer Reservoir-Schnittstelle 45 mit einem Medium-Reservoir 46 verbunden. Weiterhin kann die Fluidik-Baugruppe noch eine Reihe zusätzlicher Komponenten umfassen die üblicherweise bei Dosiersystemen dieser Art Verwendung finden, wie z. B. ein Rahmenteil 47, eine Heizungseinrichtung 48 mit Heizungsanschlusskabeln 49 etc., um nur einige zu nennen. Da der grundsätzliche Aufbau von Dosiersystemen bekannt ist, werden der besseren Übersichtlichkeit wegen hier überwiegend solche Komponenten gezeigt, die zumindest mittelbar die Erfindung betreffen.

Figur 2 zeigt einen Querschnitt auf einen Teil eines Dosiersystems gemäß einer weiteren Ausführungsform der Erfindung. Der Gehäuseblock 11 umfasst die Aktorkammer 12 in deren Innenraum die Aktoreinheit 60 angeordnet ist (hier nur exemplarisch gezeigt). Zwischen dem Gehäuse 62 und einer Innenseite 80 der Kammerwandung 79, welche den Innenraum der Aktorkammer 12 ausbildet, verbleibt ein schmaler Spalt, welcher das Gehäuse 62 hier kreisförmig umschließt und dem Kühlmittelstrom dient. Zur Zuführung des Kühlmittels in den Strömungsbereich ist die Aktorkammer 12 mittels einer Zuführöffnung 24, hier in Gestalt eines Durchbruchs 24 durch die Kammerwandung 79, mit einem Zuströmkanal 26 verbunden. Der Zuströmkanal 26 verläuft im Wesentlichen parallel zur Aktorkammer 12 durch den Gehäuseblock 11 und weist eine Anzahl von überwiegend rechtwinklig abzweigenden Kanälen auf, wobei hier aufgrund der Darstellungsweise nur jeweils eine Zuführöffnung 24 bzw. Abführöffnung 25 sichtbar ist. Ausgehend von der Zuführöffnung 24 erfolgt der Kühlmittelstrom konstruktionsbedingt (erzwungenermaßen) zu einer zugeordneten Abführöffnung 25 so, dass das Gehäuse 62 beidseitig vom Kühlmittel umströmt wird. Die Abführöffnung 25 ist zur Abführung des Kühlmittels aus der Aktorkammer 12 bzw. aus dem Dosiersystem 1 mit einem Ausströmkanal 27 verbunden.

Durch die balgartige Ausgestaltung des Gehäuses, zumindest im Bereich des Gehäusemantels (siehe Figur 6), kann erreicht werden, dass das Kühlmittel (ziel-)gerichtet von einer jeweiligen Zuführöffnung 24 zu einer damit zusammenwirkenden Abführöffnung 25 strömt. Das Kühlmittel kann dazu entlang einer jeweiligen (horizontalen) Vertiefung des balgartig bzw. wellenförmig ausgebildeten Gehäuses 62 strömen, wobei der Kühlmittelstrom nach oben bzw. unten durch die jeweils angrenzenden Ausbuchtungen begrenzt ist. Dies wird besonders in Figur 3 deutlich.

In Figur 3 soll vor allem die Wirkweise der Kühleinrichtung des Dosiersystems verdeutlicht werden, wobei andere Komponenten des Dosiersystems der besseren Übersichtlichkeit wegen nicht gezeigt sind.

Der Zuströmkanal 26 nimmt seinen Ursprung in einer einzigen Zuführöffnung 21 des Dosiersystems und verzweigt sich anschließend entlang der Aktorkammer 12 in eine Anzahl von Zuführöffnungen 24 der Aktorkammer 12. Zur Regulierung des Kühlmitteleinstroms in den Zuströmkanal 26 bzw. in die Aktorkammer 12 ist einer Kühlmittel-Zuführung 84 und der Zuführöffnung 21 eine Kühlmittelzuführeinrichtung 28, hier eine Pumpe 28, zwischengeschaltet. Die Pumpe 28 kann mittels eines Steueranschlusses 29 von der Steuereinheit 50 angesteuert werden. Alternativ zu der hier gezeigten Ausführungsform könnte die Kühlmittelzuführeinrichtung 28 bzw. die Pumpe 28 auch außerhalb des Gehäuses 11 des Dosiersystems angeordnet sein. Im Rahmen des Temperaturmanagements des Piezoaktors werden der Steuereinheit 50 Temperatur-Messwerte aus dem Gehäuse 62 mittels eines Temperatursensor-Anschlusskabels 86 zugeführt. In Abhängigkeit eines (oder mehrerer) ermittelten Temperaturwerts (Istwert) kann die Steuereinheit 50 die Pumpe 28 so ansteuern, dass ein Sollwert der Temperatur in einem bestimmten Bereich des Gehäuses 62, z. B. im Aktorkern, nicht überschritten wird. Dazu kann die der Aktorkammer 12 zugeführte Menge an z.B. Kühlmittel durch die Pumpe 28 bedarfsgerecht angepasst werden.

Alternativ zur Verwendung einer eigenen Pumpe für das Kühlmittel, z.B. um Raumluft in die Aktorkammer 12 zu blasen, kann zur Kühlung der Aktoreinheit 60 auch Druckluft aus einem Reservoir eines bereits vorhanden und für andere Zwecke mitverwendeten Pressluftsystems verwendet werden. In diesem Pressluftsystem wird Raumluft in üblicherweise komprimiert und bis zur Zuführung in die Aktorkammer 12 in einem vorhandenen Reservoir bzw. Speicher (nicht gezeigt) gespeichert werden. Die Zuströmrate der Druckluft in die Aktorkammer 12 kann z. B. mittels eines Proportionalventils (nicht gezeigt) geregelt werden, wobei das Proportionalventil, wie zuvor für die Pumpe erläutert, in Abhängigkeit zumindest eines Temperaturwerts durch die Steuereinheit 50 angesteuert werden kann.

Der Zuströmkanal 26 verläuft unmittelbar entlang einer von der Innenseite 80 der Kammerwandung 79 abgewandten Außenseite 81 der Kammerwandung 79. Mit anderen Worten wird der Zuströmkanal 26 zumindest teilweise, d. h. in Richtung der Aktorkammer 12 hin, durch die Außenseite 81 der Kammerwandung 79 begrenzt bzw. ausgebildet.

Die Aktorkammer 12 selbst ist im Inneren des Gehäuseblocks 11 durch die Innenseite 80 der Kammerwandung 79 ausgebildet. Durch die balgartige, wellenförmige Ausgestaltung des Gehäuses 62 des Piezoaktors, grenzt das Gehäuse 62 im Bereich einer jeweiligen Ausbuchtung 82 bzw. Auswölbung 82 direkt an die Innenseite 80 der Kammerwandung 79 an. Zwischen den jeweiligen Ausbuchtungen 82 sind periodisch im Wesentlichen horizontal verlaufende Einbuchtungen 83 bzw. Rillen 83 angeordnet. Die zumindest partielle balgartige Ausgestaltung des Gehäuses 62 im Bereich des Gehäusemantels 74 (siehe Figur 6) entspricht einer bevorzugten Ausgestaltungsform der Aktoreinheit 60, wie nachfolgend erläutert wird.

Die Aktoreinheit 60 ist so in der Aktorkammer 12 angeordnet, dass jeweils eine Zuführöffnung 24 und eine damit zusammenwirkende Abführöffnung 25 der Aktorkammer 12 in einer horizontalen Ebene mit einer einzelnen Rinne 83 des Gehäuses 62 angeordnet sind. Somit wird das durch eine jeweilige Zuführöffnung 24 einströmende gasförmige oder flüssige Kühlmittel entlang einer jeweiligen Rinne 83, welche vertikal durch die angrenzenden Ausbuchtungen 82 begrenzt wird, im Wesentlichen horizontal von der Zuführöffnung 24 zur zugeordneten Abführöffnung 25 geführt, wobei das Gehäuse 62 zur Wärmeabfuhr umströmt wird.

Von der jeweiligen Abführöffnung 25 gelangt das Kühlmittel in den Ausströmkanal 27, welcher, analog zum Zuströmkanal 26, eine Anzahl von Abführöffnung 25 der Aktorkammer 12 umfasst bzw. vereinigt und schließlich in einer einzigen Abführöffnung 22 des Dosiersystems mündet, welche wiederum mit einer Kühlmittel-Abführung 85 gekoppelt ist.

In Figur 4 ist im Detail ein Längsschnitt durch ein Ausführungsbeispiel einer Aktoreinheit des erfindungsgemäßen Dosiersystems gezeigt. Der Piezoaktor 61 ist in ein Gehäuse 62 hermetisch eingeschlossen. Das Gehäuse 62 umfasst einen Gehäuseboden 66, einen fest damit verbundenen Gehäusemantel 74 sowie einen den oberen Abschluss bildenden Gehäusedeckel 67. Der Piezoaktor 61 liegt dem Gehäuseboden 66 mit einem inaktiven (Fuß-)Bereich 73 direkt auf, wobei der gegenüberliegende Endbereich 73 des Piezoaktors 61 direkten Kontakt zum Gehäusedeckel 67 hat. Der Piezoaktor 61 ist fest mit dem Gehäusedeckel 67 verbunden, z. B. verklebt.

Der Gehäusedeckel 67 umfasst vier Glasdurchführungen 69, mittels derer die Kontaktstifte 65 hermetisch dicht und elektrisch isoliert aus dem Innenraum des Gehäuses 62 nach außerhalb des Gehäuses 62 geführt werden. Jeweils ein Kontaktstift 65 ist an einer Seite des Piezoaktors 61 mit jeweils einer Außenelektrode 70 des Piezoaktors 61 verbunden, z. B. verlötet. Die beiden Außenelektroden 70 verlaufen entlang der Längserstreckung des Piezoaktors 61 zwischen den beiden inaktiven Kopf- bzw. Fußbereichen 73 auf der Außenseite bzw. Oberfläche 77 des Piezoaktors 61. Dies wird besonders in Figur 5 deutlich.

Die beiden Außenelektroden 70 verbinden die im Piezoaktor 61 angeordneten und alternierend zur Oberfläche geführten Innenelektroden 71 und schließen diese zu zwei elektrisch parallel geschalteten Gruppen zusammen (siehe Figur 4). Die beiden Anschlussstifte 65 bilden somit die beiden Anschlusspole des piezokeramischen Aktors 61.

Zwei weitere Kontaktstifte 65 dienen der Kontaktierung einer Anzahl von Temperatursensoren 78 im Gehäuse. Jeder der Temperatursensoren 78 ist über ein jeweiliges Temperatursensor-Verbindungskabel (nicht gezeigt) mit den beiden Kontaktstiften 65 verbunden. Zur Kontaktierung wird den einzelnen Temperatursensoren 78 ein (konstanter) Messstrom mittels eines der beiden Kontaktstifte 65, sowie eines jeweiligen sich daran anschließenden Temperatursensor-Verbindungskabels zugeführt. Ein Messsignal (z. B. eine Spannungsänderung) jedes Temperatursensors 78 wird über ein jeweiliges Temperatursensor-Verbindungskabel (nicht gezeigt) an einen weiteren (vierten) Anschlussstift 65 übertragen. Zur Übertragung der Messsignale (Temperatur-Messwerte) einer Mehrzahl von Temperatursensoren 78 an die Steuereinheit können die einzelnen Sensorsignale, wie bereits erläutert, auf nur einen Kontaktstift 65 gelegt und in geeigneter Weise moduliert werden, sofern es sich bei den Temperatursensoren 78 um busfähige IC-Temperaturfühler handelt.

Alternativ wäre es auch möglich, jeden Temperatursensor 78 im Gehäuse mittels zwei separaten, also nur dem jeweiligen Temperatursensor 78 zugeordneten Kontaktstiften 65, zu kontaktieren (hier nicht gezeigt). Vorzugsweise kann situationsbedingt zwischen den beiden erwähnten Alternativen abgewogen werden, da die gesonderte Kontaktierung jedes einzelnen Temperatursensors 78 mittels eigener Kontaktstifte 65 zwar den elektrischen Aufwand der Modulation reduziert, gleichzeitig aber auch erhöhte Anforderungen an die Fertigung der Aktoreinheit 60 mit sich bringt.

In Figur 4 sind drei Temperatursensoren 78 in Messkontakt mit der Innenwandung des Gehäuses 62 bzw. mit dem Gehäusemantel 74 angeordnet (hier links gezeigt). Weiterhin sind auf der Oberfläche 77 des Piezoaktors 61 drei weitere Temperatursensoren 78 so angeordnet, dass jeweils ein Temperatursensor 78 der Innenwandung bzw. der Aktoroberfläche 77 auf einer gemeinsamen gedachten überwiegend horizontalen Linie befindlich sind, wie bei dem Längsschnitt erkennbar wird.

Die Aktoreinheit 60 umfasst neben dem Gehäuse 62, dem Piezoaktor 61 und den Anschlussstiften 65 noch die im Gehäuse 62 angeordnete Atmosphäre. In dem hier gezeigten Ausführungsbeispiel setzt sich die Atmosphäre aus einem flüssigen und einem festen Füllmedium 75 sowie aus einem Expansionsbereich 76 zusammen. Der Expansionsbereich 76 ist hier als Gasblase 76 bzw. gasgefüllter Bereich 76 dargestellt.

In Figur 5 ist ein Längsschnitt durch ein weiteres Ausführungsbeispiel einer Aktoreinheit 60 des Dosiersystems gezeigt. Im Unterschied zu Figur 4 sind hier auch Temperatursensoren 78 am inaktiven Fußbereich 73 sowie im inaktiven Kopfbereich 73 des Piezoaktors 61, dort in unmittelbarer Nähe zur Durchführung 69, angeordnet. Der Expansionsbereich 76 ist hier "luftballonartig" umschlossen, also stofflich getrennt vom Füllmedium 75, im Gehäuse 62 angeordnet. Aus Gründen der Übersichtlichkeit ist in Figur 5 nur ein Kotaktstift 65 gezeigt.

Im Gehäuse 62 ist weiterhin ein Dehnmessstreifen 87 an der Außenseite des Piezoaktors 61 angeordnet. Der Dehnmessstreifen 87 erstreckt sich hier im Wesentlichen entlang der gesamten Längserstreckung des gekapselten Piezoaktors 61, also zwischen einem Fußbereich 73 und einem Kopfbereich 73. Die entsprechenden Messwerte (Sensorsignale) des Dehnmessstreifens 87 können mittels Kontaktstiften 65 an die Steuereinheit des Dosiersystems übertragen werden, wie dies bereits analog für die Temperatursensoren 78 erläutert wurde. Ein weiterer Dehnmessstreifen 87 ist an der Außenseite des Gehäuses 62 angeordnet, wobei sich der Dehnmessstreifen 87 dort zwischen dem Gehäuseboden 66 und dem Gehäusedeckel 67 erstreckt und somit eine Gesamtauslenkung (inklusive einer temperaturbedingten Längenänderung) der Aktoreinheit 60 bzw. des gekapselten Piezoaktors 61 detektieren kann.

Die Figur 6 zeigt eine seitlich perspektivische Außenansicht einer weiteren Ausführungsform einer Aktoreinheit 60 für ein erfindungsgemäßes Dosiersystem. Die Aktoreinheit 60 entspricht im Wesentlichen der aus Figur 1, wobei die Kontaktstifte 65 bzw. die Durchführungen 69 bei den jeweiligen Aktoreinheiten 60 anders angeordnet sind. In Figur 6 ist deutlich der balgartig ausgestaltete Gehäusemantel 74 zu erkennen, welcher eine periodische Abfolge von Auswölbungen 82 und Vertiefungen 83 bzw. Rinnen 83 umfasst. In dem hier gezeigten Ausführungsbeispiel entspricht der bevorzugte Wärmeabgabebereich 68 der Aktoreinheit 60 im Wesentlichen dem gesamten balgartig ausgebildeten Bereich des Gehäusemantels 74 bzw. wird durch diesen gebildet. Der Wärmeabgabereichs 74 ist so ausgestaltet, dass im Rahmen des Temperaturmanagements des Piezoaktors eine möglichst effiziente Wärmeabfuhr aus dem Wärmeabgabereich 74 mittels der Kühleinrichtung erreicht wird. Das Gehäuse 62 hat einen überwiegend kreisförmigen Durchmesser D, welcher vorzugsweise größer als ein entsprechender Durchmesser des eingekapselten Piezoaktors 61 ist.

Es wird abschließend noch einmal darauf hingewiesen, dass es sich bei den vorhergehend detailliert beschriebenen Dosiersystemen lediglich um Ausführungsbeispiele handelt, welche vom Fachmann in verschiedenster Weise modifiziert werden können, ohne den Bereich der Erfindung zu verlassen. So könnte der Piezoaktor z. B. ohne eine definierte "schützende" Atmosphäre im Gehäuse angeordnet sein. Weiterhin kann das Dosiersystem zusätzlich oder alternativ zu den zuvor erläuterten Komponenten noch weitere Merkmale bzw. Baugruppen umfassen, die üblicherweise in Dosiersystemen der beschriebenen Art Verwendung finden. Weiterhin schließt die Verwendung der unbestimmten Artikel "ein" bzw. "eine" nicht aus, dass die betreffenden Merkmale auch mehrfach vorhanden sein können.

### Bezugszeichenliste

1 Dosiersystem
10 Aktor-Baugruppe
11 Gehäuseblock
12 Aktorkammer
13 Aktionskammer
14 Bewegungsmechanismus
15 Durchbruch
16 Hebel
17 Kontaktfläche Hebel
18 Hebellager
19 Aktorfeder
20 Drückstück
21 Zuführöffnung Dosiersystem
22 Abführöffnung Dosiersystem
23 Fixierschraube
24 Zuführöffnung Aktorkammer
25 Abführöffnung Aktorkammer
26 Zuströmkanal
27 Ausströmkanal
28 Pumpe
29 Steueranschluss Pumpe
30 Fluidik-Baugruppe
31 Stößel
32 Stößelspitze
33 Stößelkopf
34 Kontaktfläche Stößel
35 Stößelfeder
36 Stößeldichtung
37 Stößellager
40 Düse
41 Düsenöffnung
42 Düsenkammer
43 Dichtsitz
44 Zuführkanal
45 Reservoir-Schnittstelle
46 Medium-Reservoir
47 Rahmenteil
48 Heizungseinrichtung
49 Heizungsanschlusskabel
50 Steuereinheit
51 Steuerkabel
60 Aktoreinheit
61 piezokeramischer Aktor
62 Gehäuse
64 Aktoreinheit-Steueranschlüsse
65 Kontaktstift
66 Gehäuseboden
67 Gehäusedeckel
68 Wärmeabgabebereich
69 Glasdurchführung
70 Außenelektrode
71 Innenelektrode
72 piezoaktives Material
73 inaktiver Bereich
74 Gehäusemantel
75 Füllmedium
76 Expansionsbereich
77 Aktoroberfläche
78 Temperatursensor
79 Kammerwandung
80 Innenseite der Kammerwandung
81 Außenseite der Kammerwandung
82 Ausbuchtung Gehäusebalg
83 Einbuchtung Gehäusebalg
84 Kühlmittel-Zuführung
85 Kühlmittel-Abführung
86 Temperatursensor Anschlusskabel
87 Dehnmessstreifen
D Durchmesser
K Kippachse
R Ausstoßrichtung

## Patentansprüche

1. Dosiersystem (1) für einen Dosierstoff mit einer Düse (40), einem Zuführkanal (44) für Dosierstoff, einem Ausstoßelement (31) und einem mit dem Ausstoßelement (31) und/oder der Düse (40) gekoppelten Piezoaktor (61), wobei der Piezoaktor (61) hermetisch in ein Gehäuse (62) eingekapselt ist,
**dadurch gekennzeichnet, dass** das Gehäuse (62) einen definierten Wärmeabgabebereich (68) umfasst, wobei der Wärmeabgabebereich (68) eine Wärmesenke zur Umgebung bildet, und wobei der Wärmeabgabebereich (68) wärmetechnisch mit einer Kühleinrichtung (21, 22, 24, 25, 26, 27, 28, 84, 85) des Dosiersystems (1) gekoppelt ist.

2. Dosiersystem nach Anspruch 1, wobei das Gehäuse (62) dauerschwingfest ausgebildet ist.

3. Dosiersystem nach einem der vorstehenden Ansprüche, wobei zumindest ein Temperatursensor (78) im Inneren des Gehäuses (62) und/oder an einer Außenseite des Gehäuses (62) angeordnet ist.

4. Dosiersystem nach Anspruch 3, wobei zumindest ein Temperatursensor (78) an einer Außenseite (77) des Piezoaktors (61) und/oder im Inneren des Piezoaktors (61) angeordnet ist.

5. Dosiersystem nach Anspruch 3 oder 4, wobei zumindest ein Temperatursensor (78) an einer Innenwandung des Gehäuses (62) angeordnet ist.

6. Dosiersystem nach einem der vorstehenden Ansprüche, wobei zumindest ein Dehnmessstreifen (87) im Inneren des Gehäuses (62) und/oder an einer Außenseite des Gehäuses (62) angeordnet ist.

7. Dosiersystem nach einem der vorstehenden Ansprüche, wobei das Gehäuse (62) zumindest eine Durchführung (69) für eine Anzahl von elektrischen Leitern (65) umfasst.

8. Dosiersystem nach einem der vorstehenden Ansprüche, wobei sich im Gehäuse (62) ein wärmeleitendes Medium (75) und/oder ein Medium (75) zur Feuchtigkeitsunterdrückung befinden.

9. Dosiersystem nach einem der vorstehenden Ansprüche, wobei sich im Gehäuse (62) ein Druckausgleichsbereich (76) befindet.

10. Dosiersystem nach einem der vorstehenden Ansprüche, wobei die Kühleinrichtung (21, 22, 24, 25, 26, 27, 28, 84, 85) ein Kühlmittel nutzt, welches ein gasförmiges und/oder flüssiges Medium umfasst.

11. Dosiersystem nach einem der vorstehenden Ansprüche, wobei die Kühleinrichtung (21, 22, 24, 25, 26, 27, 28, 84, 85) so ausgebildet ist, dass mechanischer Abrieb durch das Kühlmittel aus einer Aktorkammer (12) des Dosiersystems (1) abgeführt wird.

12. Verwendung eines hermetisch in ein Gehäuse (62) eingekapselten piezokeramischen Aktors (61) in einem Dosiersystem (1) nach einem der vorstehenden Ansprüche.

13. Verfahren zum Betrieb eines Dosiersystems (1) nach einem der vorstehenden Ansprüche 1 bis 11, wobei der Betrieb des Dosiersystems (1) vorzugsweise in Abhängigkeit zumindest eines Betriebsparameters des eingekapselten Piezoaktors (61) geregelt wird.

14. Verfahren zur Herstellung eines Dosiersystems (1) zur Dosierung von Dosierstoff mit einem Piezoaktor (61), wobei der Piezoaktor (61) hermetisch in ein Gehäuse (62) eingekapselt wird und wobei das Gehäuse (62) des Piezoaktors (61) in einem Gehäuse (11) des Dosiersystems (1) angeordnet wird,
wobei das Gehäuse (62) einen definierten Wärmeabgabebereich (68) umfasst, wobei der Wärmeabgabebereich (68) eine Wärmesenke zur Umgebung bildet, und wobei der Wärmeabgabebereich (68) wärmetechnisch mit einer Kühleinrichtung (21, 22, 24, 25, 26, 27, 28, 84, 85) des Dosiersystems (1) gekoppelt wird.

## Claims

1. A metering system (1) for a metering substance, comprising a nozzle (40), a feed channel (44) for a metering substance, a discharge element (31) and a piezo actuator (61) coupled to the discharge element (31) and/or the nozzle (40), wherein the piezo actuator (61) is hermetically encapsulated in a housing (62), **characterized in that** the housing (62) comprises a defined heat dissipation zone (68), wherein the heat dissipation zone (68) forms a heat sink to the environment, and wherein the heat dissipation zone (68) is thermally coupled to a cooling device (21, 22, 24, 25, 26, 27, 28, 84, 85) of the metering system (1).

2. The metering system according to Claim 1, wherein the housing module (62) is designed to be vibration fatigue-resistant.

3. The metering system according to any one of the preceding claims, wherein at least one temperature sensor (78) is arranged inside the housing (62) and/or on an outer side of the housing (62).

4. The metering system according to Claim 3, wherein at least one temperature sensor (78) is arranged on an outer side (77) of the piezo actuator (61) and/or inside the piezo actuator (61).

5. The metering system according to Claim 3 or 4, wherein at least one temperature sensor (78) is located on an inner wall of the housing (62).

6. The metering system according to any one of the preceding claims, wherein at least one strain gauge (87) is arranged inside the housing (62) and/or on an outer side of the housing (62).

7. The metering system according to any one of the preceding claims, wherein the housing (62) comprises at least one feed-through (69) for a number of electrical conductors (65).

8. The metering system according to any one of the preceding claims, wherein a thermally conducting medium (75) and/or a medium (75) for moisture suppression are located in the housing (62).

9. The metering system according to any one of the preceding claims, wherein a pressure compensation zone (76) is located in the housing (62).

10. The metering system according to any one of the preceding claims, wherein the cooling device (21, 22, 24, 25, 26, 27, 28, 84, 85) uses a coolant which comprises a gaseous and/or liquid medium.

11. The metering system according to any one of the preceding claims, wherein the cooling device (21, 22, 24, 25, 26, 27, 28, 84, 85) is designed in such a way that mechanical abrasion debris is removed from an actuator chamber (12) of the metering system (1) by the coolant.

12. Use of a piezoceramic actuator (61) hermetically encapsulated in a housing (62) in a metering system (1) according to any one of the preceding claims.

13. A method for operating a metering system (1) according to any one of the preceding Claims 1 to 11, wherein the operation of the metering system (1) is preferably regulated as a function of at least one operating parameter of the encapsulated piezo actuator (61).

14. A method for producing a metering system (1) for metering a metering substance, having a piezo actuator (61), wherein the piezo actuator (61) is hermetically encapsulated in a housing (62) and wherein the housing (62) of the piezo actuator (61) is arranged in a housing (11) of the metering system (1), wherein the housing (62) comprises a defined heat dissipation zone (68) wherein the heat dissipation zone (68) forms a heat sink to the environment, and wherein the heat dissipation zone (68) is thermally coupled to a cooling device (21, 22, 24, 25, 26, 27, 28, 84, 85) of the metering system (1).

## Revendications

1. Système de dosage (1) pour une substance à doser avec une buse (40), un canal d'alimentation (44) pour la substance à doser, un élément d'éjection (31) et un actionneur piézoélectrique (61) couplé à l'élément d'éjection (31) et/ou à la buse (40), dans lequel l'actionneur piézoélectrique (61) est encapsulé hermétiquement dans un boîtier (62), **caractérisé en ce que** le boîtier (62) comprend une zone de dissipation thermique définie (68), dans lequel la zone de dissipation thermique (68) forme un dissipateur thermique pour l'environnement et dans lequel la zone de dissipation thermique (68) est couplée thermiquement à un dispositif de refroidissement (21, 22, 24, 25, 26, 27, 28, 84, 85) du système de dosage (1).

2. Système de dosage selon la revendication 1, dans lequel le boîtier (62) est conçu pour résister à la fatigue.

3. Système de dosage selon une des revendications précédentes, dans lequel au moins un capteur de température (78) est disposé à l'intérieur du boîtier (62) et/ou sur une face extérieure du boîtier (62).

4. Système de dosage selon la revendication 3, dans lequel au moins un capteur de température (78) est disposé sur une face extérieure (77) de l'actionneur piézoélectrique (61) et/ou à l'intérieur de l'actionneur piézoélectrique (61).

5. Système de dosage selon la revendication 3 ou 4, dans lequel au moins un capteur de température (78) est disposé sur une paroi intérieure du boîtier (62).

6. Système de dosage selon une des revendications précédentes, dans lequel au moins une jauge de contrainte (87) est disposée à l'intérieur du boîtier (62) et/ou sur une face extérieure du boîtier (62).

7. Système de dosage selon une des revendications précédentes, dans lequel le boîtier (62) comprend au moins un passage (69) pour un certain nombre de conducteurs électriques (65).

8. Système de dosage selon une des revendications précédentes, dans lequel un milieu conducteur de chaleur (75) et/ou un milieu (75) pour la suppression de l'humidité sont situés dans le boîtier (62).

9. Système de dosage selon une des revendications précédentes, dans lequel une zone d'égalisation de pression (76) est située dans le boîtier (62).

10. Système de dosage selon une des revendications précédentes, dans lequel le dispositif de refroidissement (21, 22, 24, 25, 26, 27, 28, 84, 85) utilise un fluide de refroidissement, qui comprend un milieu gazeux et/ou liquide.

11. Système de dosage selon une des revendications précédentes, dans lequel le dispositif de refroidissement (21, 22, 24, 25, 26, 27, 28, 84, 85) est conçu de telle sorte que l'abrasion mécanique soit éliminée par le liquide de refroidissement hors d'une chambre d'actionnement (12) du système de dosage (1).

12. Utilisation d'un actionneur piézocéramique (61) hermétiquement encapsulé dans un boîtier (62) dans un système de dosage (1) selon une des revendications précédentes.

13. Procédé de fonctionnement d'un système de dosage (1) selon une quelconque des revendications précédentes 1 à 11, dans lequel le fonctionnement du système de dosage (1) est de préférence régulé en fonction d'au moins un paramètre de fonctionnement de l'actionneur piézoélectrique encapsulé (61).

14. Procédé de fabrication d'un système de dosage (1) pour le dosage d'une substance à l'aide d'un actionneur piézoélectrique (61), dans lequel l'actionneur piézoélectrique (61) est encapsulé hermétiquement dans un boîtier (62) et dans lequel le boîtier (62) de l'actionneur piézoélectrique (61) est disposé dans un boîtier (11) du système de dosage (1),
dans lequel le boîtier (62) comprend une zone de dissipation thermique définie (68), dans lequel la zone de dissipation thermique (68) forme un dissipateur thermique pour l'environnement, et dans laquelle la zone de dissipation thermique (68) est couplée thermiquement à un dispositif de refroidissement (21, 22, 24, 25, 26, 27, 28, 84, 85) du système de dosage (1).
